(19) Europäisches Patentamt / European Patent Office / Office européen des brevets

(11) **EP 4 604 005 A1**

(12) **EUROPEAN PATENT APPLICATION**
published in accordance with Art. 153(4) EPC

(43) Date of publication:
**20.08.2025   Bulletin 2025/34**

(21) Application number: **23937344.2**

(22) Date of filing: **28.12.2023**

(51) International Patent Classification (IPC):
*G06F 40/284* (2020.01)

(52) Cooperative Patent Classification (CPC):
**G06F 17/16; G06F 40/284; G06N 3/0464;**
**G06N 3/048; G06N 3/08; H04L 69/04**

(86) International application number:
**PCT/CN2023/142953**

(87) International publication number:
**WO 2024/234673 (21.11.2024 Gazette 2024/47)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority:   **18.05.2023   CN 202310567601**

(71) Applicant: ZTE CORPORATION
**Shenzhen, Guangdong 518057 (CN)**

(72) Inventors:
• **FENG, Yulong**
  **Shenzhen, Guangdong 518057 (CN)**
• **XU, Jin**
  **Shenzhen, Guangdong 518057 (CN)**
• **HU, Liujun**
  **Shenzhen, Guangdong 518057 (CN)**
• **YU, Guanghui**
  **Shenzhen, Guangdong 518057 (CN)**

(74) Representative: **Deambrogi, Edgardo et al**
**Jacobacci & Partners S.p.A.**
**Corso Emilia 8**
**10152 Torino (IT)**

(54) **VECTOR MATRIX DETERMINATION METHOD AND SYSTEM, STORAGE MEDIUM, AND ELECTRONIC DEVICE**

(57)    The present disclosure provides a vector matrix determination method and system, a storage medium, and an electronic device. The method comprises: coding a message to be transmitted into a codeword matrix, wherein the codeword matrix comprises a regular codeword matrix and an irregular codeword matrix, and the codeword matrix is a three-dimensional codeword matrix; and converting the codeword matrix by means of a fully-connected network group to obtain a vector matrix having the same codeword length. The technical solution solves the technical problems in the related art that existing semantic communication systems do not relate to classical data coding and the semantic communication systems cannot fuse classical communication due to sentences required to be transmitted having the same length.

**Fig. 3**

Encoding a message to be transmitted into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix — S302

Transforming the codeword matrix through a group of fully-connected networks to obtain a vector matrix in which codewords have the same codeword lengths — S304

## Description

The present disclosure claims priority to Chinese Patent Application No. 202310567601.X, filed with the China National Intellectual Property Administration (CNIPA) on May 18, 2023 and entitled "Vector Matrix Determination Method and System, Storage Medium, and Electronic Device", which is incorporated herein by reference in its entirety.

## Technical Field

The present disclosure relates to the field of communications, and in particular, to a vector matrix determination method and system, a storage medium, and an electronic device.

## Background

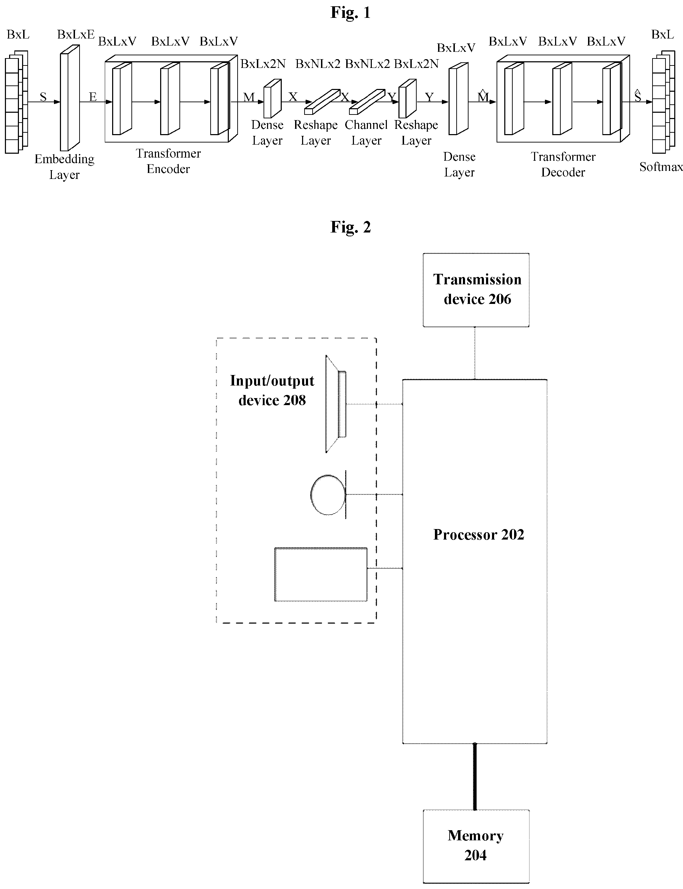

In related field, a Deep Learning based Semantic Communication (DeepSC) model is widely used in semantic communication systems. The structure of the DeepSC model is illustrated in Fig. 1.

In addition to the aforementioned DeepSC model, there are many other semantic communication models, such as Deep Learning based Semantic Communication-Lite (DeepSC-L), Universal Transformer-based semantic communication systems, and variable coding rate semantic communication systems. These semantic communication models require a One-Hot vector with a fixed length as an input for semantic encoding.

Moreover, the semantic communication systems in the related art generally use a Machine Learning (ML) framework and leverage powerful nonlinear fitting capabilities of Artificial Neural Networks (ANN) to extract semantic redundancy behind the information. However, due to the complexity of natural language, the semantic communication systems in the related art mainly adopt Joint Source-Channel encoding (JSCC) schemes in which source encoding and channel encoding are jointly performed and cannot be separated. Additionally, as the ANN can only handle data with a fixed length, such system implementation schemes cannot handle information with a variable length. This shortcoming makes it difficult to integrate the semantic communication systems with classical communication systems and significantly limits data compression potential of semantic communication.

In summary, the semantic communication systems in the related art do not involve classical data encoding and require transmitted sentence lengths to be identical. These transmission conditions/requirements greatly limit the application scenarios of semantic communication and are not conducive to integrating the semantic communication with classical communication. It should be noted that there are currently no cases of integration between semantic encoding and classical encoding.

In response to the technical problems/shortcomings that a semantic communication systems in the related art does not involve classical data encoding and requires transmitted sentence lengths to be identical, leading to the inability to integrate the semantic communication system with classical communication, no effective solutions have been proposed to date.

Therefore, it is necessary to improve the related art to overcome the aforementioned shortcomings.

## Summary

Embodiments of the present disclosure provide a vector matrix determination method and system, a storage medium, and an electronic device, which may at least solve the problem that a semantic communication systems in the related art does not involve classical data encoding and requires transmitted sentence lengths to be identical, leading to the inability to integrate the semantic communication system with classical communication.

According to an aspect of the embodiments of the present disclosure, a vector matrix determination method is provided, including: encoding a message to be transmitted into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix; and transforming the codeword matrix through a group of fully-connected networks to obtain a vector matrix in which codewords have the same codeword lengths.

In an exemplary embodiment, the group of fully-connected networks includes a plurality of fully-connected networks having different input lengths but the same output lengths, a size of a second dimension of two-dimensional parameters of the plurality of fully-connected networks is related to a number of words in a word list corresponding to a natural language used when training the plurality of fully-connected networks, and the vector matrix serves as an input of a semantic encoding module, wherein the vector matrix is a three-dimensional vector matrix.

In an exemplary embodiment, before the transforming the codeword matrix through a group of fully-connected networks to obtain a vector matrix in which codewords have the same codeword lengths, the vector matrix determination method further includes: obtaining a codeword length of each codeword in the codeword matrix; and determining the codeword length as a size of a first dimension of the two-dimensional parameters of a fully-connected network corresponding to the each codeword.

In an exemplary embodiment, the transforming the codeword matrix through a group of fully-connected networks to obtain a vector matrix in which codewords have the same codeword lengths includes: inputting the each codeword in the codeword matrix into the fully-connected network corresponding to the each codeword, and determining a vector A in the vector matrix corresponding to the each codeword by using the following formula:

$$\mathbf{A}=\mathbf{W}^{i}h+b^{i},$$

wherein $h$ represents the each codeword in the codeword matrix, and $\mathbf{W}^{i}$ and $b^{i}$ represent the two-dimensional parameters of a fully-connected network corresponding to an i-th codeword in the codeword matrix, wherein the size of the first dimension of $\mathbf{W}^{i}$ and $b^{i}$ is the codeword length of the i-th codeword; and

obtaining the vector matrix according to a position of the each codeword in the codeword matrix and the vector A corresponding to the each codeword.

In an exemplary embodiment, after the transforming the codeword matrix through a group of fully-connected networks to obtain a vector matrix in which codewords have the same codeword lengths, the vector matrix determination method further includes: obtaining a probability vector corresponding to each third dimension vector of the vector matrix; determining a target vector according to the probability vector, wherein the target vector is a vector with a maximum element of the each third dimension vector being set to a first value; and combining a plurality of target vectors into a target matrix.

In an exemplary embodiment, the determining a target vector according to the probability vector includes: determining, according to the probability vector, noise data corresponding to the each third dimension vector; and determining the target vector according to the noise data and the probability vector, wherein the noise data is used for ensuring that the target vector is not a constant value.

In an exemplary embodiment, after the transforming the codeword matrix through a group of fully-connected networks to obtain a vector matrix in which codewords have the same codeword lengths, the vector matrix determination method further includes: directly inputting the vector matrix into a first fully-connected network of a semantic encoding module, wherein a size of a first dimension of the two-dimensional parameter of the first fully-connected network is related to the number of the words in the word list.

In an exemplary embodiment, after the transforming the codeword matrix through a group of fully-connected networks to obtain a vector matrix in which codewords have the same codeword lengths, the vector matrix determination method further includes: dividing the vector matrix in a direction of a third dimension of the vector matrix, so as to obtain multiple sub-vector matrices; and transforming the multiple sub-vector matrices into multiple sub-target matrices, and determining a target matrix according to the multiple sub-target matrices.

In an exemplary embodiment, the transforming the codeword matrix through a group of fully-connected networks to obtain a vector matrix in which codewords have the same codeword lengths includes: obtaining a maximum codeword length of the codeword matrix; padding target positions in the codeword matrix with second values according to the maximum codeword length, so as to obtain a padded codeword matrix in which the codeword lengths of all the codewords are equal to the maximum codeword length; and transforming all the codewords in the padded codeword matrix through the group of fully-connected networks to obtain the vector matrix in which the codewords have the same codeword lengths.

In an exemplary embodiment, the vector matrix determination method includes: in a case where the message to be transmitted is encoded by using an arithmetic encoding algorithm or a Lempel-Ziv (LZ) encoding algorithm, obtaining a two-dimensional codeword matrix corresponding to the arithmetic encoding algorithm or the LZ encoding algorithm; obtaining a three-dimensional codeword matrix corresponding to the two-dimensional codeword matrix, and swapping a first dimension and a second dimension of the three-dimensional codeword matrix to obtain an inputtable matrix, wherein a size of a third dimension of the inputtable matrix is a maximum codeword length of the codeword matrix; and determining a second fully-connected network in which a size of a first dimension of the two-dimensional parameters is the maximum codeword length and a size of the second dimension of the two-dimensional parameters is related to the number of the words in the word list; and transforming each codeword in the inputtable matrix through the second fully-connected network, so as to obtain the vector matrix in which the codewords have the same codeword lengths.

In an exemplary embodiment, the encoding a message to be transmitted into a codeword matrix includes at least one of: encoding the message to be transmitted into the codeword matrix by using a Huffman encoding algorithm; encoding the message to be transmitted into the codeword matrix by using an arithmetic encoding algorithm; encoding the message to be transmitted into the codeword matrix by using a Lempel-Ziv (LZ) encoding algorithm; encoding the message to be transmitted into the codeword matrix by using a Huffman encoding algorithm, and truncating the codeword matrix according to a target length to form a lossy encoded codeword matrix.

In an exemplary embodiment, the first value is a positive number, and the second value is a value smaller than the first value.

According to another aspect of the embodiments of the present disclosure, a vector matrix determination system is provided, including an encoding module, configured to encode a message to be transmitted into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix; and a data semantic transformation module, coupled with the encoding module and configured to transform the codeword matrix through a group of fully-connected networks to obtain a vector matrix in which codewords have the same codeword lengths.

In an exemplary embodiment, the vector matrix determination system further includes: a semantic encoding module, coupled with the data semantic transformation module and whose embedding layer is replaced with a first fully-connected network, and configured to receive the vector matrix through the first fully-connected network.

According to still another aspect of the embodiments of the present disclosure, a computer readable storage medium is provided. The computer readable storage medium stores a computer program, and the computer program is configured to execute the vector matrix determination method during running.

According to yet another aspect of the embodiments of the present disclosure, an electronic device is provided, including a memory and a processor, wherein the memory stores a computer program, and the processor is configured to execute the vector matrix determination method by running the computer program.

By means of the embodiments of the present disclosure, a message to be transmitted is encoded into a codeword matrix; and the codeword matrix is transformed through a group of fully-connected networks to obtain a vector matrix in which codewords have the same codeword lengths. That is to say, by encoding a message to be transmitted into a three-dimensional codeword matrix, and transforming the obtained codeword matrix into a vector matrix in which codewords have the same codeword lengths, the technical problem that a semantic communication systems in the related art does not involve classical data encoding and requires transmitted sentence lengths to be identical, leading to the inability to integrate the semantic communication system with classical communication is solved. The technical effect of integrating classical encoding with semantic encoding of a semantic communication system of the related art is achieved, and by integrating the classical encoding and the semantic encoding, to-be-transmitted sentences with different lengths are able to be processed.

**Brief Description of the Drawings**

The drawings described herein are intended to provide further understanding of the present disclosure, and form a part of the present disclosure. The exemplary embodiments of the present disclosure and the description thereof are used to explain the present disclosure, and do not form improper limits to the present disclosure. In the drawings:

Fig. 1 is a schematic structural diagram of a DeepSC model in the related art;

Fig. 2 is a block diagram illustrating the hardware structure of a computer terminal for implementing a vector matrix determination method according to some embodiments of the present disclosure;

Fig. 3 is a flowchart of a vector matrix determination method according to some embodiments of the present disclosure;

Fig. 4 is a schematic diagram of architecture of a semantic encoding system in the related art;

Fig. 5 is a schematic diagram (1) illustrating a difference between classical source encoding and semantic encoding according to some embodiments of the present disclosure;

Fig. 6 is a schematic diagram (2) illustrating a difference between classical source encoding and semantic encoding according to some embodiments of the present disclosure;

Fig. 7 is a schematic diagram (3) illustrating a difference between classical source encoding and semantic encoding according to some embodiments of the present disclosure;

Fig. 8 is a schematic diagram (4) illustrating a difference between classical source encoding and semantic encoding according to some embodiments of the present disclosure;

Fig. 9 is a schematic diagram (5) illustrating a difference between classical source encoding and semantic encoding according to some embodiments of the present disclosure;

Fig. 10 is a schematic diagram of semantic information according to some embodiments of the present disclosure;

Fig. 11 is a schematic structural diagram of a system for integrating classical Huffman encoding and semantic encoding according to some embodiments of the present disclosure;

Fig. 12 is a schematic structural diagram of a system for integrating classical Huffman encoding and improved semantic encoding according to some embodiments of the present disclosure;

Fig. 13 is a schematic structural diagram of a system for integrating classical Huffman encoding and semantic encoding added with a "Many-Hot" vector transformation module according to some embodiments of the present disclosure;

Fig. 14 is a schematic structural diagram of a system for integrating classical Huffman encoding and semantic encoding employing a padding mechanism according to some embodiments of the present disclosure;

Fig. 15 is a schematic structural diagram of a system for integrating arithmetic encoding and semantic encoding according to some embodiments of the present disclosure;

Fig. 16 is a schematic structural diagram of a system for integrating LZ encoding and semantic encoding according to some embodiments of the present disclosure;

Fig. 17 is a schematic structural diagram of a multi-language semantic encoding and decoding system according to some embodiments of the present disclosure; and

Fig. 18 is a block diagram of a vector matrix determination system according to some embodiments of the present disclosure.

## Detailed Description of the Embodiments

In order to make those having ordinary skill in the art better understand the solutions of the present disclosure, the technical solutions in the embodiments of the present disclosure will be clearly and completely described as follows with reference to the accompanying drawings in the embodiments of the present disclosure. Apparently, the described embodiments are merely a part rather than all of the embodiments of the present disclosure. All other embodiments obtained by those having ordinary skill in the art based on the embodiments of the present disclosure without creative efforts shall belong to the scope of protection of the present disclosure.

It should be noted that, terms such as "first" and "second" in the description, claims, and accompanying drawings of the present disclosure are used to distinguish similar objects, but are not necessarily used to describe a specific sequence or order. It should be understood that the data so used may be interchanged where appropriate so that the embodiments of the present disclosure described herein may be implemented in sequences other than those illustrated or described herein. In addition, the terms "include" and "have", and any variations thereof, are intended to cover a non-exclusive inclusion, for example, a process, method, system, product, or apparatus that includes a series of operations or units is not necessarily limited to those operations or units that are expressly listed, but may include other operations or units that are not expressly listed or inherent to such process, method, product, or apparatus.

The method embodiments provided in the embodiments of the present disclosure may be executed in a computer terminal or a similar computing device. Taking the implementation of the vector matrix determination method on a computer terminal as an example, Fig. 2 is a block diagram illustrating the hardware structure of a computer terminal for implementing a vector matrix determination method according to some embodiments of the present disclosure. As shown in Fig. 2, the computer terminal may include one or more processors 202 (only one is shown in Fig. 2) (the one or more processors 202 may include, but are not limited to, a Microprocessor Unit (MPU), or a Programmable Logic Device (PLD)) and a memory 204 for storing data. In an exemplary embodiment, the computer terminal may further include a transmission device 206 for communication functions and an input/output device 208. Those having ordinary skill in the art may understand that the structure shown in Fig. 2 is merely exemplary, which does not limit the structure of the foregoing computer terminal. For example, the computer terminal may include more or fewer components than shown in Fig. 2, or have different configurations with equivalent functionality or more features than those shown in Fig. 2.

The memory 204 may be configured to store a computer program, for example, a software program and modules of application software, such as a computer program corresponding to the vector matrix determination method in the embodiments of the present disclosure. The one or more processors 202 execute various function applications and data processing by running the computer program stored in the memory 204, that is, the foregoing method is implemented. The memory 204 may include a high-speed random access memory, and may also include a non-volatile memory, such as one or more magnetic storage devices, flash memory, or other non-volatile solid-state memory. In some instances, the memory 204 may further include a memory remotely located with respect to the one or more processors 202, and this remotely located memory may be connected to the computer terminal over a network. Examples of such networks include, but are not limited to, the Internet, intranets, local area networks, mobile communication networks, and combinations thereof.

The transmission device 206 is configured to receive or transmit data via a network. Specific examples of the described network may include a wireless network provided by a communication provider of the computer terminal. In an example, the transmission device 206 may include a Network Interface Controller (NIC) that may be coupled to other network devices via a base station to communicate with the Internet. In an example, the transmission device 206 may be a Radio Frequency (RF) module for communicating wirelessly with the Internet.

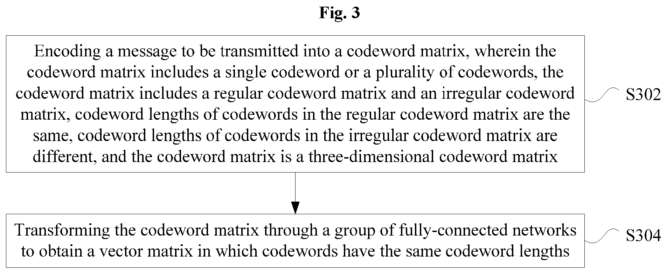

Fig. 3 is a flowchart of a vector matrix determination method according to some embodiments of the present disclosure. As shown in Fig. 3, the vector matrix determination method may include the following operations S302 to S304.

In operation S302, a message to be transmitted is encoded into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix.

In operation S304, the codeword matrix is transformed through a group of fully-connected networks to obtain a vector matrix in which codewords have the same codeword lengths.

By means of the above operations, a message to be transmitted is encoded into a codeword matrix; and the codeword matrix is transformed through a group of fully-connected networks to obtain a vector matrix in which codewords have the same codeword lengths. That is to say, by encoding a message to be transmitted into a three-dimensional codeword matrix, and transforming the obtained codeword matrix into a vector matrix in which codewords have the same codeword lengths, the technical problem that a semantic communication systems in the related art does not involve classical data encoding and requires transmitted sentence lengths to be identical, leading to the inability to integrate the semantic communication system with classical communication is solved. The technical effect of integrating classical encoding with semantic encoding of a semantic communication system of the related art is achieved, and by integrating the classical encoding and the semantic encoding, to-be-transmitted sentences with different lengths are able to be processed.

In an exemplary embodiment, the group of fully-connected networks includes a plurality of fully-connected networks having different input lengths but the same output lengths, a size of a second dimension of two-dimensional parameters of the plurality of fully-connected networks is related to a number of words in a word list corresponding to a natural language used when training the plurality of fully-connected networks, and the vector matrix serves as an input of a semantic encoding module, wherein the vector matrix is a three-dimensional vector matrix.

In an exemplary embodiment, the operation of encoding the message to be transmitted into the codeword matrix includes at least one of: encoding the message to be transmitted into the codeword matrix by using a Huffman encoding algorithm; encoding the message to be transmitted into the codeword matrix by using an arithmetic encoding algorithm; encoding the message to be transmitted into the codeword matrix by using a Lempel-Ziv (LZ) encoding algorithm; encoding the message to be transmitted into the codeword matrix by using a Huffman encoding algorithm, and truncating the codeword matrix according to a target length to form a lossy encoded codeword matrix.

That is, the message to be transmitted is encoded into the codeword matrix by using a classical encoding algorithm, where the classical encoding algorithm includes, but is not limited to, a Huffman encoding algorithm, an arithmetic encoding algorithm, and an LZ encoding algorithm. In some exemplary implementations, the codeword matrix obtained by using the Huffman encoding algorithm may further be truncated according to a certain length (i.e., the target length), so as to form a lossy encoded codeword matrix.

In an exemplary embodiment, before the operation of transforming the codeword matrix through the group of fully-connected networks to obtain the vector matrix in which the codewords have the same codeword lengths, the vector matrix determination method may further include operations of: obtaining a codeword length of each codeword in the codeword matrix; and determining the codeword length as a size of a first dimension of the two-dimensional parameters of a fully-connected network corresponding to the each codeword.

After the message to be transmitted is input to a classical encoding module adopting the classical encoding algorithm, the classical encoding module transforms and outputs the message to be transmitted as a codeword matrix. In general, the output codeword matrix includes a plurality of codewords, and the codeword lengths of the codewords in the output codeword matrix are not equal lengths. However, it is also possible to obtain a codeword matrix including a plurality of codewords having the same codeword length, or obtain a codeword matrix only having one codeword.

In an exemplary embodiment of the present disclosure, a classical encoding module is merged with a semantic encoding module of a semantic communication system, and a data-semantic information transformation module is used to transform a codeword matrix output by the classical encoding module into a vector matrix that can be input to the classical encoding module. In some exemplary implementations, the data-semantic information transformation module may include a group of fully-connected networks, and is configured to transform the codeword matrix output by the classical encoding module into a vector matrix in which codewords have the same codeword lengths, so that the vector matrix can be input into the semantic communication system conveniently. Specifically, the group of fully-connected networks includes a plurality of fully-connected networks, and the number of the plurality of fully-connected networks may be the same as the number of codewords in the codeword matrix. A size of a first dimension of two-dimensional parameters of each fully-connected network in the plurality of fully-connected networks is equal to a codeword length of a codeword to be processed corresponding to each fully-connected network. For example, the size of the first dimension of the fully-connected network corresponding to the codeword with the codeword length of 1 is 1, and the size of the first dimension of the fully-connected network corresponding to the codeword with the codeword length of 2 is 2, and so on.

In an exemplary embodiment, the operation of transforming the codeword matrix through the group of fully-connected networks to obtain the vector matrix in which codewords have the same codeword lengths includes: inputting the each codeword in the codeword matrix into the fully-connected network corresponding to the each codeword, and determining a vector **A** in the vector matrix corresponding to the each codeword by using the following formula:

$$\mathbf{A}=\mathbf{W}^{i}h+b^{i}\,,$$

wherein h represents the each codeword in the codeword matrix, and $\mathbf{W}^{i}$ and $b^{i}$ represent the two-dimensional parameters of a fully-connected network corresponding to an i-th codeword in the codeword matrix, wherein the size of the first dimension of $\mathbf{W}^{i}$ and $b^{i}$ is the codeword length of the i-th codeword; and obtaining the vector matrix according to a position of the each codeword in the codeword matrix and the vector **A** corresponding to the each codeword.

It can be understood that the fully-connected network transforms the codeword in the codeword matrix into the vector in the vector matrix by means of the described formula. Specifically, each codeword in the codeword matrix is input into a corresponding fully-connected network, and the codeword is transformed by means of the described formula to obtain the vector corresponding to the codeword, After transforming all the codewords in the codeword matrix into corresponding vectors, the obtained vectors are combined into the vector matrix according to the position of each codeword in the codeword matrix.

The size of the second-dimension of the two-dimensional parameters $\mathbf{W}^{i}$ and $b^{i}$ in the above formula are both related to a size of a word list used during training, and the size of the word list used during training is equal to the number of words in the word list corresponding to the natural language used during training. In an exemplary embodiment, if the natural language used during training is Chinese and 7000 words exist in the corresponding word list, the size of the second dimension of the two-dimensional parameters of the plurality of fully-connected networks included in the group of fully-connected network is 7000. It should be noted that the obtained vector matrix is a three-dimensional vector matrix with fixed dimensions, and a size of the third dimension of the vector matrix is related to the size of the word list used during training, wherein the size of the word list used in training is the number of words in the word list corresponding to the natural language used in training, for example, in a case where the size of the second dimension of the two-dimensional parameters of the group of fully-connected networks is 7000, the size of the third dimension of the vector matrix is 7000.

It should be noted that, the foregoing value "7000" is only an example, and is not used to limit the present disclosure. In addition, it can be deduced by analogy that a natural language used during training is not limited to Chinese, and the size of the word list used during training is also not limited to 7000 words, but is related to an actual size of the word list corresponding to the natural language used during training.

An Embedding layer of the semantic encoding module requires an input vector in a One-Hot form (referred to as a One-Hot vector). It should be noted that the One-Hot vector is a method for transforming discrete, categorical data into continuous vector representations. In the One-Hot vector, each category is encoded into a vector with only one dimension being set to 1 and all other dimensions being set to 0. The use of the One-Hot vector facilitates the transformation of any number of different labels into dense and low-dimensional vectors with fixed lengths, with these vectors being independent of each other and having no inherent relationships. Therefore, in many machine learning algorithms, input data is often encoded into the One-hot vector form for processing.

Thus, after transforming the codeword matrix into the vector matrix, the following alternative operations may be performed.

1) One alternative is to further transform the vector matrix into an input vector in a One-Hot form.

In an exemplary embodiment, after the operation of transforming the codeword matrix through a group of fully-connected networks to obtain a vector matrix in which codewords have the same codeword lengths, the vector matrix determination method may further include: obtaining a probability vector corresponding to each third dimension vector of the vector matrix; determining a target vector according to the probability vector, wherein the target vector is a vector with a maximum element of the each third dimension vector being set to a first value; and combining a plurality of target vectors into a target matrix.

In an exemplary embodiment, the operation of determining the target vector according to the probability vector includes: determining, according to the probability vector, noise data corresponding to the each third dimension vector; and determining the target vector according to the noise data and the probability vector, wherein the noise data is used for ensuring that the target vector is not a constant value.

It is understandable that dividing the vector matrix into multiple probability vectors according to the third dimension essentially highlights a maximum value in each probability vector, i.e., a probability value of the probability vector corresponding to the maximum value in each third-dimension vector is the largest among probability values of all probability vectors corresponding to the third-dimension vector.

In order to ensure that the target vector is not a constant value, thus allowing for gradient back propagation, re-parameterization techniques can be employed.

In an exemplary embodiment, Gumbel noise is added to the probability vector, specifically including: determining corresponding noise data based on the third-dimension vector, i.e., calculating noise data corresponding to each vector element in the third-dimension vector; adding each probability element in the obtained probability vector to its corresponding noise data, so as to obtain a target probability vector (i.e., the target vector in the aforementioned embodiment); and combining all target probability vectors to obtain the target matrix, i.e., the One-Hot form input matrix, and inputting the target matrix to the Embedding layer of the semantic encoding module.

2) Another alternative is to replace the Embedding layer in the semantic encoding module so as to remove the restriction of the input vector in the One-Hot form required by the Embedding layer.

In an exemplary embodiment, after the operation of transforming the codeword matrix through a group of fully-connected networks to obtain a vector matrix in which codewords have the same codeword lengths, the vector matrix determination method further includes: directly inputting the vector matrix into a first fully-connected network of a semantic encoding module, wherein a size of a first dimension of the two-dimensional parameter of the first fully-connected network is related to the number of the words in the word list.

In an exemplary embodiment of the present disclosure, a size of a first dimension of the two-dimensional parameters of a fully-connected network replacing the Embedding layer is the same as a size of the third dimension of the target vector. In this way, the vector matrix may be directly input into the semantic encoding module, thereby avoiding the need of transforming the vector matrix into the input vector in the One-Hot form.

In an exemplary embodiment, after the operation of transforming the codeword matrix through a group of fully-connected networks to obtain a vector matrix in which codewords have the same codeword lengths, the vector matrix determination method further includes: dividing the vector matrix in a direction of a third dimension of the vector matrix, so as to obtain multiple sub-vector matrices; and transforming the multiple sub-vector matrices into multiple sub-target matrices, and determining a target matrix according to the multiple sub-target matrices.

A feasible solution for dividing the vector matrix in the direction of the third dimension of the vector matrix includes: dividing the vector matrix according to a maximum codeword length of the codeword matrix corresponding to the vector matrix, wherein the number of the multiple sub-vector matrices (i.e., the number of sub-vector matrices into which the vector matrix is divided) is related to the codeword length in the corresponding codeword matrix. A more specific solution is that the number of sub-vector matrices into which the vector matrix is divided is related to a value obtained by subtracting the codeword length of the codeword corresponding to the vector in the vector matrix from the maximum codeword length. For example, if the codeword length of the codeword corresponding to a certain vector in the vector matrix is 2, and the maximum codeword length is 8, then the number of the divided multiple sub-vector matrices is equal to 8-2=6. If the vectors of the vector matrix cannot be equally divided according to the number of sub-vector matrices into which the vector matrix is divided, the remaining elements may be discarded, or the group of elements that cannot be equally divided is taken as the last group.

In an exemplary embodiment, the operation of transforming the codeword matrix through the group of fully-connected networks to obtain the vector matrix in which codewords have the same codeword lengths includes: obtaining a maximum codeword length of the codeword matrix; padding target positions in the codeword matrix with second values according to the maximum codeword length, so as to obtain a padded codeword matrix in which the codeword lengths of all the codewords are equal to the maximum codeword length; and transforming all the codewords in the padded codeword matrix through the group of fully-connected networks to obtain the vector matrix in which the codewords have the same codeword lengths.

In some exemplary implementations, the codeword matrix is first padded according to the maximum codeword length of the codeword matrix, so as to obtain a padded codeword matrix in which all the codewords have the same codeword length.

For example, it is assumed that the message to be transmitted is **S**, the message **S** is formed by $B$ sentences each having a length of $L$, and the length $L$ indicates that there are $L$ words in the corresponding sentence. In a case where a classical encoding module is a Huffman encoding module, the codeword matrix output by the Huffman encoding module is a three-dimensional codeword matrix with a dimension of $[B, L, H_{ij}]$, where $H_{ij}$ denotes a Huffman codeword length obtained by encoding the $j$-th word of the $i$-th sentence, the Huffman codeword lengths are unequal lengths with a maximum codeword length being denoted as $\max(H_{ij})$. In a case where the codeword matrix is padded with second values, a padded codeword matrix with the same codeword length can be obtained, and the padded codeword matrix has a dimension of $[B, L, \max(H_{ij})]$.

In addition, a data-semantic transformation module using the padded codeword matrix as an input may transform the padded codeword matrix into the vector matrix by using only a two-dimensional fully-connected network with a parameter size $[\max(H_{ij}), CorpusLen]$. It should be noted that *CorpusLen* is related to a size of a word list used during training, and the size of the word list used during training is equal to the number of words in the word list corresponding to a natural language used during training. In an exemplary embodiment of the present disclosure, the structure of the data-semantic transformation module may be made simpler.

In an exemplary embodiment, the vector matrix determination method includes: in a case where the message to be transmitted is encoded by using an arithmetic encoding algorithm or a Lempel-Ziv (LZ) encoding algorithm, obtaining a two-dimensional codeword matrix corresponding to the arithmetic encoding algorithm or the LZ encoding algorithm; obtaining a three-dimensional codeword matrix corresponding to the two-dimensional codeword matrix, and swapping a first dimension and a second dimension of the three-dimensional codeword matrix to obtain an inputtable matrix, wherein a size of a third dimension of the inputtable matrix is a maximum codeword length of the codeword matrix; determining a second fully-connected network in which a size of a first dimension of the two-dimensional parameters is the maximum codeword length and a size of the second dimension of the two-dimensional parameters is related to the number of the words in the word list; and transforming each codeword in the inputtable matrix through the second fully-connected network, so as to obtain the vector matrix in which the codewords have the same codeword lengths.

In a case where the classical encoding module adopts an arithmetic encoding algorithm or an LZ encoding algorithm, the codeword matrix obtained after transforming the message to be transmitted is a two-dimensional codeword matrix. Further, the data-semantic information transformation module corresponding to the arithmetic encoding algorithm or the LZ encoding algorithm may be selected to be a data-semantic information transformation module formed by a convolution layer, a Reshape layer, and a fully-connected layer (equivalent to the second fully-connected network in the above embodiments).

Therefore, the operation of obtaining the three-dimensional codeword matrix corresponding to the two-dimensional codeword matrix includes: in a case where the two-dimensional codeword matrix has a shape of $[B,H_i]$, where $H_i$ denotes an arithmetic encoding codeword length obtained by encoding the $i$-th sentence, and a longest length is denoted as $\max(H_i)$, padding the two-dimensional codeword matrix to obtain a padded two-dimensional codeword matrix whose size is $[B,\max(H_i)]$; and obtaining the three-dimensional codeword matrix according to the padded two-dimensional codeword matrix when a certain condition is satisfied.

In some exemplary implementations, the operation of obtaining the three-dimensional codeword matrix according to the padded two-dimensional codeword matrix when the certain condition is satisfied includes: processing the padded two-dimensional codeword matrix through a convolution layer with the number of layer channels being $L$ and a core size being 1*1, in a case where a padding number P and a step length S of the convolution layer satisfy the following relationship:

$$\begin{cases} \dfrac{P_H}{S_H\text{-}1} = B \\[4mm] \dfrac{P_W}{S_W\text{-}1} = \max(H_i) \end{cases},$$

wherein $P_H$, $S_H$ represents the padding number and the step length in a column direction, and $P_W$, $S_W$ represents the padding number and the step length in a row direction; and obtaining a three-dimensional codeword matrix corresponding to the padded two-dimensional codeword matrix through the convolution layer, wherein the three-dimensional codeword matrix has a dimension of $[L,B, \max(H_i)]$.

Further, a first dimension and a second dimension of the obtained three-dimensional codeword matrix are swapped to obtain an inputtable matrix, and the inputtable matrix is input to a second fully-connected network with a parameter size of $[\max(H_i),CorpusLen]$, so as to obtain a vector matrix with a dimension of *[B,L,CorpusLen]*. For a solution of inputting the vector matrix to the semantic encoding module, reference may be made to other embodiments of the present disclosure, and details are not repeatedly described herein.

In the exemplary embodiment described above, the first value is a positive number, and the second value is a value smaller than the first value. For example, in a case where the first value is set to be a positive number of 2, the second value may take a value smaller than 2.

The vector matrix determination method is further described in the following embodiments.

With reference to Fig. 1, an operating manner of the DeepSC model is described as follows. A message that a source needs to transmit is denoted as **S**, the message **S** is composed of $B$ sentences each having a length of $L$, the length $L$ represents that there are $L$ words (in English) in each sentence, then the message **S** may be expressed as:

$$\mathbf{S} = \begin{bmatrix} w_{11} & w_{12} & \dots & w_{1L} \\ w_{21} & w_{22} & \dots & w_{2l} \\ \dots & \dots & \dots & \dots \\ w_{B1} & w_{B2} & \dots & w_{BL} \end{bmatrix},$$

where $\{w_{ij}; i = 1,2,...,B. j = 1,2,...,L\}$ represents the *j*-th word of the *i*-th sentence.

The message **S** is then encoded into a One-Hot vector with the size of *[B,L,CorpusLen],* where *CorpusLen* represents the number of different words contained in the entire message. The message then passes through an Embedding layer in which a parameter $\mathbf{W}_{Embedding}$ with the shape (dimension) of [*CorpusLen,E*] is stored, and after the Embedding layer, a word distribution vector **E** with the dimension of [*B,E*] is obtained.

$$\mathbf{E} = \mathbf{SW}_{Embedding}.$$

In Natural Language Processing (NLP), the word distribution vector may represent a correlation between word meanings, and can be regarded as codewords that have taken word meanings into account, that is, the first step of semantic encoding has been carried out to represent the original message **S** in a most efficient physical carrier (the word distribution vector)..

Subsequently, position information of each word of the word distribution vector **E** needs to be calculated, and a calculation formula is as follows:

$$\begin{cases} PE(pos,n) = \sin(pos/10000^{n/E}), & n = 2i \\ PE(pos,n) = \cos(pos/10000^{n/E}), & n = 2i+1 \end{cases},$$

where $pos = [1,2,...,L], n = [1,2,...,E]$. The position information is added to the calculated word distribution vector **E** element by element to obtain a new word distribution vector taking into account the position information. The new word distribution vector is still represented by **E** and is obtained according to the following formula:

$$\mathbf{E} = \mathbf{E} \oplus PE(pos,n),$$

where $\oplus$ denotes element by element addition.

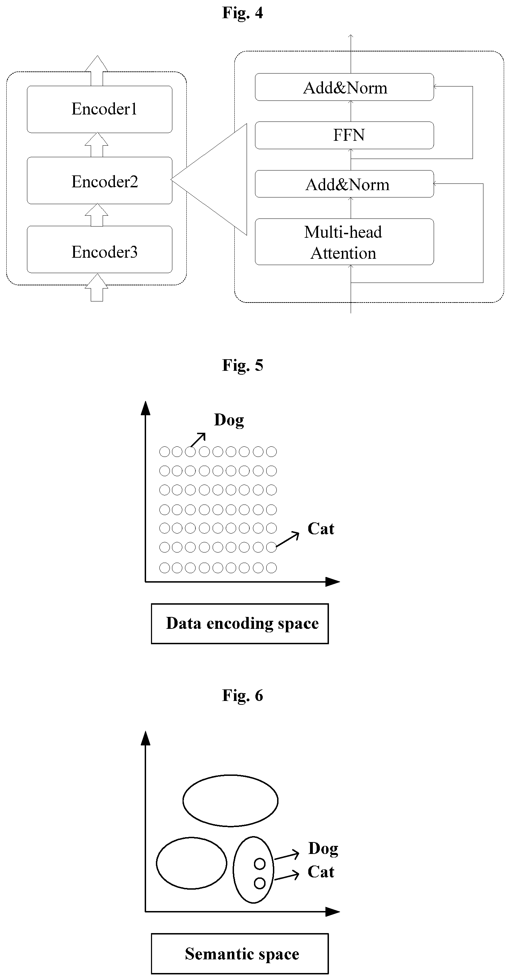

Then, the word distribution vector **E** taking into account the position information passes through the Encoder of the Transformer (also referred to as Transformer Encoder) to calculate inter-correlations. As shown in Fig. 4, the Transformer Encoder used in the semantic communication system includes 3 encoders (i.e., the Encoders in Fig. 4), and the structure of each Encoder is shown in the dashed box on the right side of Fig. 4, which includes an 8-head attention layer (i.e., the multi-head attention layer in Fig. 4) and two fully-connected layers.

It should be noted that the FNN in Fig. 4 stands for Feedforward Neural Network.

The word distribution vector **E** is first input into the multi-head attention layer, and the 8-head attention layer divides the word distribution vector **E** equally into eight parts, and then uses the following parameters:

$$\mathbf{W}_Q = \{\mathbf{W}_Q^1, \ \mathbf{W}_Q^2, \ \ldots, \ \mathbf{W}_Q^8\},$$

$$\mathbf{W}_K = \{\mathbf{W}_K^1, \ \mathbf{W}_K^2, \ \ldots, \ \mathbf{W}_K^8\},$$

$$\mathbf{W}_V = \{\mathbf{W}_V^1, \ \mathbf{W}_V^2, \ \ldots, \ \mathbf{W}_V^8\}.$$

to embed the original word vector into subspaces to obtain the following three feature vectors:

$$\mathbf{Q} = \{\mathbf{Q}^1, \ \mathbf{Q}^2, \ \ldots, \ \mathbf{Q}^8\} = \mathbf{SW}_Q^T,$$

$$\mathbf{K} = \{\mathbf{K}^1, \ \mathbf{K}^2, \ \ldots, \ \mathbf{K}^8\} = \mathbf{SW}_K^T,$$

$$\mathbf{V} = \{\mathbf{V}^1, \ \mathbf{V}^2, \ \ldots, \ \mathbf{V}^8\} = \mathbf{SW}_V^T.$$

Then, attention operations are performed on these three feature vectors to obtain the following output vector **O**, which has the same shape as the input word vector **E**:

$$\mathbf{O} = \text{soft}\max\left(\frac{\mathbf{Q}\mathbf{K}^{\mathrm{T}}}{\sqrt{E}}\right)\mathbf{V}\ .$$

After that, the output vector **O** is subjected to residual connections and layer normalization to ultimately obtain an attention output **H.** The attention output **H** further needs to pass through two fully-connected layers:

$$\mathbf{Z} = \text{Re}\,\text{lu}(\mathbf{O}\mathbf{W}_1 + b_1)\mathbf{W}_2 + b_2\ .$$

The vector **Z** transformed by the fully-connected layers is again subjected to residual connections and layer normalization to ultimately obtain an output vector **M** . Through the aforementioned operations, the encoding of the message **S** by one Encoder is completed. Since 3 Encoders are used here, the above process needs to be carried out two more times to obtain a final output which is also denoted as **M.** Through the aforementioned attention mechanism operations, the second step of semantic encoding is completed, that is, some syntactic correlation information is extracted.

Then, the output vector **M** first passes through a dense layer, which performs channel encoding on the output vector to obtain a channel transmission vector **X:**

$$\mathbf{X} = \text{Re}\,\text{lu}(\mathbf{Z}\mathbf{W}_{\text{Dense}} + b_{\text{Dense}})\ .$$

After the channel transmission vector **X** is transmitted through an AWGN channel, the channel transmission vector **X** becomes **Y**, and then **Y** is decoded at the destination end. The decoding process is essentially the inverse of the encoding process, so it will not be detailed here.

Based on the above explanation, a joint encoding module for data and semantics is proposed in the embodiments of the present disclosure in combination with classical encoding schemes

Specifically, in order to solve the problem that a semantic communication systems in the related art does not involve classical data encoding and requires transmitted sentence lengths to be identical, leading to the inability to integrate the semantic communication system with classical communication, and further improve the source encoding in the semantic communication, a semantic communication encoding module for variable-length encoded inputs is proposed in the exemplary embodiments of the present disclosure. The input of this encoding module may be source encoding of a classical encoding system, such as Huffman encoding or arithmetic encoding. In this system, these classical encoded codewords are further optimized such that they can be further improved based on semantic redundancy information implied by the context and ultimately sent over an air interface via a channel to the receiver. The semantic decoding system at the receiver may remain unchanged.

More information that can facilitate the understanding is provided as follows.

Semantic communication is a novel paradigm that has emerged in recent years. Based on this paradigm, communication systems will not only consider redundancy present in encoded data, i.e., the data redundancy compressed by source encoding and the data redundancy added by channel coding to combat noise, but also consider the redundancy present in the natural language meaning represented by the encoded data, which is referred to as semantic redundancy.

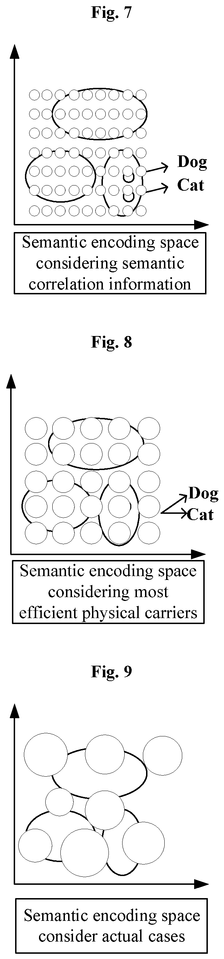

In classical source encoding, only data redundancy is considered. As shown in Fig. 5, each black dot represents one codeword, and these codewords are unrelated to each other. However, classical source encoding does not consider the semantics represented by these codewords. In the semantic space, as shown in Fig. 6, the meanings represented by these codewords may be related, for example, "cat" and "dog" in Fig. 6 share some common characteristics, such as both being small animals and being kept as pets. These codewords may overlap in certain contexts, as shown in Figs. 7 and 8. Depending on different context and the meanings of the codewords, these codewords can be further compressed. However, the correlation between natural languages is not as straightforward as numbers; natural languages are more complex and may be nonlinear. Therefore, the final representation may be as shown in Fig. 9.

Due to the complexity of natural languages, they may be non-stationary, have memory, and be nonlinear, which means that natural languages do not meet the additivity condition required for the Shannon entropy formula. A simple example is the interpretation of words when taking words out of context. Therefore, semantic communication systems cannot be described using a classical Shannon model, which is why semantic communication systems adopt Artificial Neural Network (ANN)-based Joint Source-Channel Coding (JSCC) architecture. To better describe a data and semantics integrated encoding module proposed in the embodiments of the present disclosure, it is necessary to first define the new concepts in the semantic communication systems in detail.

Semantic information $S$ : The amount of semantic information of a message $M$ is defined as a sum of semantic information contained in data $e$ that carries the message $M$ and semantic correlation information between the data $e$ (where $e \subset E$ ) in the semantic space:

$$S(M) = wf(\delta_e) = \lambda(\delta_e) \otimes cor(\delta_e)$$

Here, $\otimes$ represents a high-dimensional operation, which is a makeshift representation when semantic feature information and specific functional forms of semantic correlation information cannot be determined. $e$ represents a set of individual data that composes the message $M$, and belongs to some physical carrier **E**, such as English or Chinese, i.e., $e \subset E$.

Semantic correlation information function cor: It represents the semantic information produced by the arrangement of multiple single data due to corresponding grammatical rules under the current physical carrier, and is denoted by the cor function.

Semantic feature information function $\lambda$: It represents the remaining information that can characterize the semantic features of the data after extracting the correlation information produced by the arrangement of single data under the current physical carrier.

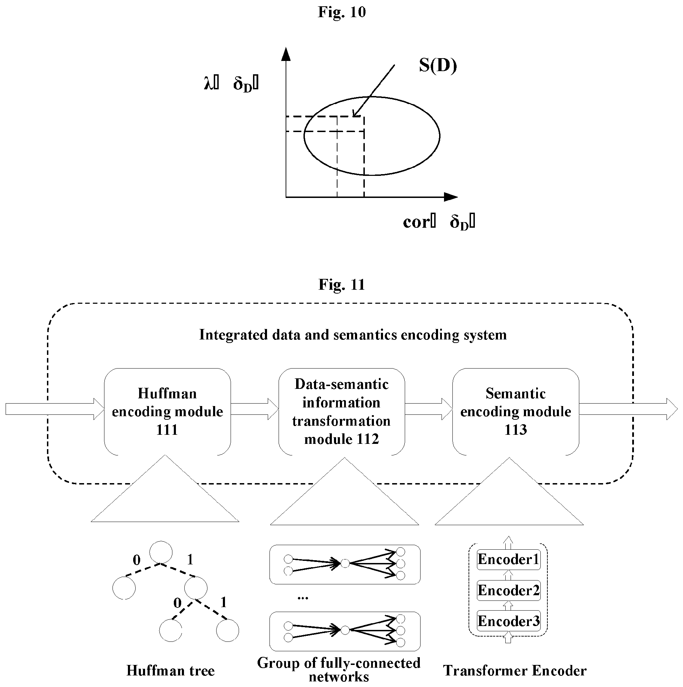

The above definitions can be simply illustrated in Fig. 10. Semantic information is high-dimensional information. The simple diagram here only represents the semantic information in two dimensions, but in reality, semantic feature information and semantic correlation information may be high-dimensional, and operations performed between the semantic feature information and semantic correlation information may also be high-dimensional.

It should be noted that the semantic correlation information here has at least the following two characteristics.

The first characteristic is meaning correlation information, i.e., the correlation between word meanings. This type of information is similar to the word vector representation in deep learning, such as Word2Vec.

The second characteristic is syntactic correlation information, i.e., the correlation between contexts. This type of information is similar to language models in natural language processing.

The embodiments of the present disclosure consider that semantic encoding is divided into two steps. The first step is to transform the message $M$ to represent identical semantics using the most efficient physical carrier based on meaning correlation information, where "most efficient" refers to the minimal amount of data information. The second step is to extract the syntactic correlation information contained in the transformed information representation, leaving only enough syntactic correlation information for decoding.

The following exemplary embodiments are provided to illustrate the above embodiment.

Exemplary Embodiment 1: Huffman encoding and semantic encoding integration scheme:

Exemplary embodiment 1 of the present disclosure involves a method for integrating Huffman encoding with semantic encoding, particularly relates to a module for transforming classical source encoding into semantic encoding in the field of communication, and this module is referred to as a data-semantic information transformation module. The related device may be applied to a transmitting end device. In this module, not only is the data redundancy of the original message compressed, but it is also mapped with semantic redundancy, allowing Huffman encoding of variable lengths to be semantically encoded and semantic redundancy to be compressed.

The embodiment includes a Huffman encoding and semantic encoding integration device, with the system structure as shown in Fig. 11. The Huffman encoding and semantic encoding integration device includes: a Huffman encoding module 111, a data-semantic information transformation module 112, and a semantic encoding module 113. The aforementioned modules can be one or more dedicated or general-purpose hardware modules, separate or integrated chips, memory, etc., with corresponding functions or technical features. The modules may alternatively be one or more embedded or non-embedded dedicated or general-purpose software, software modules, software codes, operating systems, or a combination of one or more hardware and software.

Furthermore, the Huffman encoding module is primarily responsible for conducting Huffman encoding. Assuming the input message is **S**, composed of $B$ sentences each having the length of $L$, and the length $L$ represents that there are $L$ words (in English) in each sentence, then the message **S** may be expressed as:

$$\mathbf{S} = \begin{bmatrix} w_{11} & w_{12} & \dots & w_{1L} \\ w_{21} & w_{22} & \dots & w_{2l} \\ \dots & \dots & \dots & \dots \\ w_{B1} & w_{B2} & \dots & w_{BL} \end{bmatrix}$$

where $\{w_{ij}; i = 1,2,...,B. j = 1,2,...,L\}$ represents the $j$-th word of the $i$-th sentence.

The message matrix **S** first passes through the Huffman encoding module, which is mainly composed of a Huffman tree, reducing the number of bits required to represent the data. Variable-length codewords may be used to represent each word in the message matrix **S**. That is, the message matrix **S** is expanded into a Huffman codeword matrix **H,** with the shape $[B,L,H_{ij}]$, where $H_{ij}$ represents the length of the Huffman codeword obtained by encoding the $j$-th word of the *i*-th sentence, and different $H_{ij}$ are of variable lengths. For ease of description, the longest Huffman codeword length is denoted as max($H_{ij}$).

Furthermore, the data-semantic transformation module is designed to resolve the conflict between semantic correlation information and data redundancy information. The data-semantic transformation module jointly considers Huffman encoding and semantic encoding, achieving feature mapping between Huffman encoding and semantic encoding and performing balanced encoding. Additionally, the data-semantic transformation module includes two sub-modules: a redundancy mapping module and a One-Hot vector generation module.

1) The redundancy mapping module establishes a mapping relationship between data encoding and semantic encoding. This mapping relationship is constituted by a set of fully connected layers (equivalent to the fully connected network group in the aforementioned embodiments), and the size of the parameter of each fully connected layer (equivalent to the fully connected network in the aforementioned embodiments) is related to the length $H_{ij}$ of the Huffman encoded codewords and a preset output length *CorpusLen* . Here, *CorpusLen* is a positive integer. The final output matrix is denoted as $\mathbf{A}_{\text{code}}$.

Specifically, regarding the redundancy mapping module:

Generally, words that appear more frequently in the message **S** have shorter Huffman codewords, but in natural language, these words may have richer structured information when combined with other words, representing a broader semantic range, i.e., these words may have richer semantic correlation information. Correspondingly, in the semantic encoding stage, more semantic redundancy information may need to be extracted. Conversely, words with lower frequency have longer Huffman codewords, but these words may have less semantic correlation information, and less semantic redundancy information may need to be extracted in the semantic encoding stage. The data-semantic transformation module will not only consider the data redundancy of the message **S** but also the semantic correlation information redundancy of the message **S**, further attempt to establish a mapping between the data redundancy and the semantic correlation information redundancy, and find a balanced encoding point.

After the Huffman codeword matrix is input into the data-semantic information transformation module, the Huffman codeword matrix will be transformed into codewords that consider structured information (i.e., consider semantic correlation information) based on the codeword length and by using fully connected layers. The fully connected layers contain parameters whose sizes are determined by the Huffman codeword length, and Huffman codewords h of different lengths will be mapped to vectors of the same dimension:

$$\mathbf{A}=\mathbf{W}_{\text{Huffman}}{}^{i}h + b_{\text{Huffman}}{}^{i}$$

where $\mathbf{W}_{\text{Huffman}}{}^{i}$ and $b_{\text{Huffman}}{}^{i}$ represent parameters of different dimensions, with the size of the first dimension being equal to the length of the corresponding Huffman codeword. For instance, for a Huffman codeword with the length $H_{ij}$ being equal to 1, a parameter size of the fully connected layer into which this Huffman codeword is input is equal to [1,*CorpusLen*]; for a Huffman codeword with the length $H_{ij}$ being equal to 2, a parameter size of the fully connected layer into which this Huffman codeword is input is equal to [2,*CorpusLen*], and so on. The length of the longest Huffman codeword is denoted as max($H_{ij}$).

For Huffman codewords of length $H_{ij}$ , although the Huffman encoding lengths of these Huffman codewords are different, after passing through the data-semantic information transformation module, the resulting vector matrix $\mathbf{A}_{\text{code}}$ composed of vectors **A** has a size of *[B,L,CorpusLen]*, where the length of each codeword is expanded to *CorpusLen* , representing its structured relationship with other codewords. Thus, through the data-semantic information transformation module, a mapping between data redundancy and semantic correlation information redundancy is achieved.

2) The One-Hot vector generation module can output a vector **B** with one element being 1 and all other elements being 0. Additionally, a re-parameterization technique is employed. This re-parameterization technique satisfies the gradient back propagation conditions during network training. To illustrate how this technique solves the gradient propagation issue and illustrate the data changes in this embodiment, an example is provided. For instance, assuming that a third-dimension vector in the matrix $\mathbf{A}_{\text{code}}$ is denoted as $\pi$, and has a length of *CorpusLen* , the following transformation is performed on the third-dimension vector.

Specifically:

Softmax is performed on the vector matrix $\mathbf{A}_{\text{code}}$ to correspond the vector matrix $\mathbf{A}_{\text{code}}$ to a One-Hot vector input of the original semantic encoder (i.e., the semantic encoding module). Here, the argmax function can be directly used to select the largest element in each row of **A**, the largest element is set to 1, thus forming a new One-Hot vector **B**. However, it should be noted that since the argmax function itself is not differentiable, it will cause gradients to not propagate backward during training, resulting in the parameters in the data-semantic information transformation module not being updated. Therefore, a re-parameterization technique, such as the Gumbel-Softmax Trick, can be used to achieve the aforementioned process. A specific exemplary implementation process is as follows.

The third-dimension vector in matrix $\mathbf{A}_{code}$ is denoted as $\pi$, and has a length of *CorpusLen* . Softmax is first performed on the vector $\pi$ to obtain the occurring probability of each element:

$$p_i = soft\max(\pi_i) = \frac{\pi_i}{\sum\limits_{j=1}^{CorpusLen} \pi_j}$$

Gumbel noise is added to the occurring probability $p_i$ of $\pi_i$ :

$$x_{\pi_i} = \arg\max(\log(p_i) + G_i)$$

where $G_i$ is referred to as Gumbel noise:

$$G_i = -\log(-\log(U_i)), \quad U_i \sim U(0,1)$$

This noise is used to make the output $x_{\pi i}$ not fixed. The final vector composed of $x_{\pi i}$ is a One-Hot vector. However, since there is still the issue of the argmax function being non-differentiable, the Softmax function is used as a replacement:

$$x_{\pi_i} = \text{softmax}(\log(p_i) + G_i) = \frac{\exp[(\log(p_i) + G_i)/\tau]}{\sum\limits_{j=1}^{CorpusLen} \exp[(\log(p_j) + G_j)/\tau]}$$

where $\tau$ is called a scaling parameter. When $\tau$ is sufficiently small, $x_\pi$ approaches a One-Hot vector and is differentiable.

Based on the optional scheme mentioned above, the resulting vector composed of $x_{\pi i}$ can serve as the input to the semantic encoding module.

Furthermore, the new One-Hot vector **B** subsequently passes through the Embedding layer of the semantic encoding module, resulting in a vector matrix having the size of [*B,L,E*], which is then subjected to semantic encoding operations.

Through the aforementioned operations, during the joint training of the semantic encoder and decoder, the Huffman encoding module stores data redundancy information, the data-semantic information transformation module stores a correspondence between data redundancy and semantic correlation information, and the semantic encoding module stores the extracted semantic correlation information, thereby completing the integrated encoding process of semantics and data.

The innovation of Exemplary Embodiment 1 of the present disclosure at least includes: constructing a data-semantic transformation module that represents the mapping between data redundancy and semantic redundancy, allowing for joint consideration during encoding to achieve optimal encoding; combining multiple fully connected networks to form a fully connected network group that uniformly processes classic codewords of different encoding lengths; and using a re-parameterization technique to convert classic encoding representations that cannot be back propagated into probabilities, enabling the entire system to be optimized through back propagation algorithms.

Exemplary Embodiment 2: Direct integration scheme of Huffman encoding with improved semantic encoding: Exemplary Embodiment 2 involves a method for improving the design of a semantic encoding module, thereby further optimizing the design of the data-semantic information transformation module and reducing the overall complexity of the device.

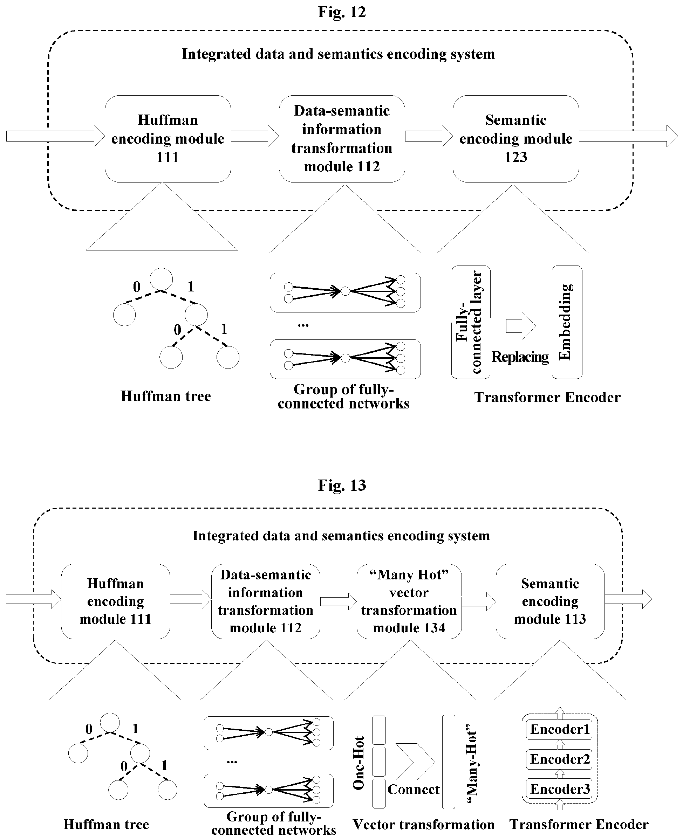

The system structure of Exemplary Embodiment 2 is shown in Fig. 12.

Fig. 12 is a schematic structural diagram of a system for integrating classical Huffman encoding and improved semantic encoding according to some embodiments of the present disclosure. Based on Fig. 11, the Embedding layer of the original semantic encoding module is replaced with a fully connected layer to achieve its connection with the preceding data-semantic information transformation module. Fig. 12 includes: a Huffman encoding module 111, a data-semantic information transformation module 112, and an improved semantic encoding module 123. The aforementioned modules can be one or more dedicated or general-purpose hardware modules, separate or integrated chips, memory, etc., with corresponding functions or technical features. The modules may alternatively be one or more embedded or non-embedded dedicated or general-purpose software, software modules, software codes, operating systems, or a combination of one or more hardware and software.

Exemplary embodiment 2 is derived from Exemplary embodiment 1 of the present disclosure, and the difference from Exemplary embodiment 1 lies in that:

The data-semantic transformation module only includes a redundancy mapping module and does not need to use the re-parameterization technique to transform vectors in matrix $\mathbf{A}_{code}$, instead, the data-semantic transformation module directly outputs matrix $\mathbf{A}_{code}$.

The Embedding layer of the semantic encoding module is replaced by a fully connected layer, so matrix $\mathbf{A}_{code}$ can be used as input directly.

The execution process of the improved scheme in Exemplary Embodiment 2 is described as follows.

In Exemplary Embodiment 2 of the present disclosure, it is assumed that the incoming message is **S,** composed of *B* sentences each having the length of *L,* and the length *L* represents that there are *L* words (in English) in each sentence, then the message **S** may be expressed as:

$$\mathbf{S} = \begin{bmatrix} W_{11} & W_{12} & \dots & W_{1L} \\ W_{21} & W_{22} & \dots & W_{2I} \\ \dots & \dots & \dots & \dots \\ W_{B1} & W_{B2} & \dots & W_{BL} \end{bmatrix}.$$

The message matrix **S,** after passing through the Huffman encoding module and the data-semantic transformation module, ultimately results in a vector matrix $\mathbf{A}_{code}$ having the size of *[B,L,CorpusLen].* However, since $\mathbf{A}_{code}$ is not a One-Hot vector, it cannot be directly used as input for the semantic encoding module.

The fundamental reason is that the Embedding layer requires input vectors in the One-Hot form. The input vectors in the One-Hot form can be considered as inputs where only one situation has a probability of 1. The Embedding layer is used to reduce computational effort. Without considering computational effort, a fully connected layer with parameter size [*CorpusLen,E*] can be directly used to replace the Embedding layer, so the vector matrix $\mathbf{A}_{code}$ can be directly used as input for the semantic encoding module. After the vector matrix $\mathbf{A}_{code}$ passes through the fully connected layer, a vector matrix having the size of [*B,L,E*] is obtained for subsequent semantic encoding operations.

The innovation of Exemplary Embodiment 2 of the present disclosure at least includes: utilizing the principle of Embedding implementation, replacing the Embedding layer with a fully connected layer to store word distribution vectors, expanding its input data requirements, so that there is no longer a need for a One-Hot vector generation module in the data-semantic information transformation module. This not only simplifies the design structure but also incorporates all semantic correlation information corresponding to data encoding into the scope of computation for the integrated encoding system.

Exemplary Embodiment 3: Huffman encoding transformation and semantic encoding integration scheme

Exemplary Embodiment 3 of the present disclosure involves an improved "Many-Hot" vector transformation module, which transforms the output of the data-semantic information transformation module into a valid input for the semantic encoding module, while considering the inverse correlation between data encoding and semantic encoding, making the overall system design more rational.

Fig. 13 is a schematic structural diagram of a system for integrating classical Huffman encoding and semantic encoding, in which a "Many-Hot" vector transformation module is added, according to some embodiments of the present disclosure. The system includes: a Huffman encoding module 111, a data-semantic information transformation module 112, a semantic encoding module 113, and a "Many-Hot" vector transformation module 134. The aforementioned modules can be one or more dedicated or general-purpose hardware modules, separate or integrated chips, memory, etc., with corresponding functions or technical features. The modules may alternatively be one or more embedded or non-embedded dedicated or general-purpose software, software modules, software codes, operating systems, or a combination of one or more hardware and software.

Exemplary Embodiment 3 of the present disclosure is derived from Exemplary Embodiment 1, and the difference from Exemplary Embodiment 1 is the addition of the "Many-Hot" vector transformation module after the data-semantic information transformation module.

The "Many-Hot" vector transformation module establishes a possible inverse correlation mapping relationship between data encoding and semantic encoding, and can further transform the output matrix of the data-semantic transformation module into "Many-Hot" vectors.

Furthermore, the inverse correlation mapping relationship refers to the fact that the higher the frequency of a word in the original message, the shorter the corresponding Huffman codeword, and the more information that needs semantic encoding the word may contain, thus giving this word a greater weight during semantic encoding. The converse is also true.

Additionally, the "Many-Hot" vectors undergo grouping operations, and each group is subjected to the One-Hot vector generation module operations described in Exemplary Embodiment 1.

The grouping operation is performed for each vector according to the third dimension of the matrix $\mathbf{A}_{code}$, and this corresponds to the third dimension of the Huffman codeword matrix, which is the dimension that stores the codewords. The number of groups (i.e., the number of groups that is divided) is inversely correlated with the corresponding Huffman codeword length, that is, if the corresponding codeword length is $H_{ij}$, then the number of groups is $\max(H_{ij})-H_{ij}$. If the matrix cannot be divided equally, the remaining elements may be discarded, or the remaining elements can be taken as the last group.

The operation of the One-Hot vector generation module can pass the grouped vectors through the One-Hot vector generation module described in Exemplary Embodiment 1, and then concatenate the resulting vectors.

The execution process of Exemplary Embodiment 3 is specifically described as follows.

Assuming the incoming message is **S** which is composed of $B$ sentences each having the length of $L$, and the length $L$ represents that there are $L$ words (in English) in each sentence, then the message **S** may be expressed as:

$$\mathbf{S} = \begin{bmatrix} w_{11} & w_{12} & ... & w_{1L} \\ w_{21} & w_{22} & ... & w_{2l} \\ ... & ... & ... & ... \\ w_{B1} & w_{B2} & ... & w_{BL} \end{bmatrix}$$

The message matrix **S** first passes through the Huffman encoding module to obtain a Huffman codeword matrix **H** with a shape of $[B,L,H_{ij}]$, where $H_{ij}$ represents the length of the Huffman codeword obtained by encoding the $j$-th word of the $i$-th sentence, and different $H_{ij}$ are of variable lengths. The longest Huffman codeword length is denoted as $\max(H_{ij})$.

After the codeword matrix **H** passes through the data-semantic transformation module, a vector matrix $\mathbf{A}_{code}$ having the size of *[B,L,CorpusLen]* is obtained. However, since $\mathbf{A}_{code}$ is not a One-Hot vector, $\mathbf{A}_{code}$ cannot be directly used as input for the semantic encoding module.

At the same time, the higher the frequency of a word in the original message, the shorter the corresponding Huffman codeword, but the word may contain more semantic correlation information that needs to be considered for semantic encoding. Conversely, the lower the frequency of a word, the longer the corresponding Huffman codeword, but the word may contain less semantic correlation information that needs to be considered for semantic encoding. Therefore, there may be an inverse correlation between data redundancy and semantic redundancy.

Therefore, to reflect the inverse correlation between data redundancy and semantic redundancy, and to transform the vector matrix $\mathbf{A}_{code}$ into a valid input for the semantic encoding module, a "Many-Hot" vector transformation module is designed here, which operates on the data in two steps.

First, the vector matrix $\mathbf{A}_{code}$ is divided into groups for each vector according to the third dimension of the vector matrix, and this corresponds to the third dimension of the Huffman codeword matrix, which is the dimension that stores the codewords. The number of groups (i.e., the number of groups that is divided) is inversely correlated with the corresponding Huffman codeword length, that is, if the corresponding codeword length is $H_{ij}$, then the number of groups is $\max(H_{ij}) - H_{ij}$. If the matrix cannot be divided equally, the remaining elements may be discarded, or the remaining elements can be taken as the last group. Such grouping corresponds to the inverse correlation relationship between data redundancy and semantic redundancy.

Then, the grouped vectors are each subjected to the re-parameterization technique described in Exemplary Embodiment 1 to transform the vectors into One-Hot vectors, which are then concatenated to ultimately obtain a "Many-Hot" vector. Such "Many-Hot" vector can be accepted as valid inputs by the semantic encoding module.

The innovation of Exemplary Embodiment 3 of the present disclosure at least includes: the vector matrix $\mathbf{A}_{code}$ representing probabilities is divided into groups and then encoded to ultimately obtain a "Many-Hot" vector that reflect different semantic redundancy relationships, and the "Many-Hot" vector can serve as an input for the semantic encoding module.

Exemplary Embodiment 4: Huffman encoding and semantic encoding integration scheme with padding mechanism:

Exemplary embodiment 4 of the present disclosure involves an improved Huffman encoding method with a padding mechanism, enabling it to be input into a data-semantic information transformation module that consists of only one fully connected network, significantly simplifying the design complexity of the data-semantic information transformation module and saving storage and computational resources.

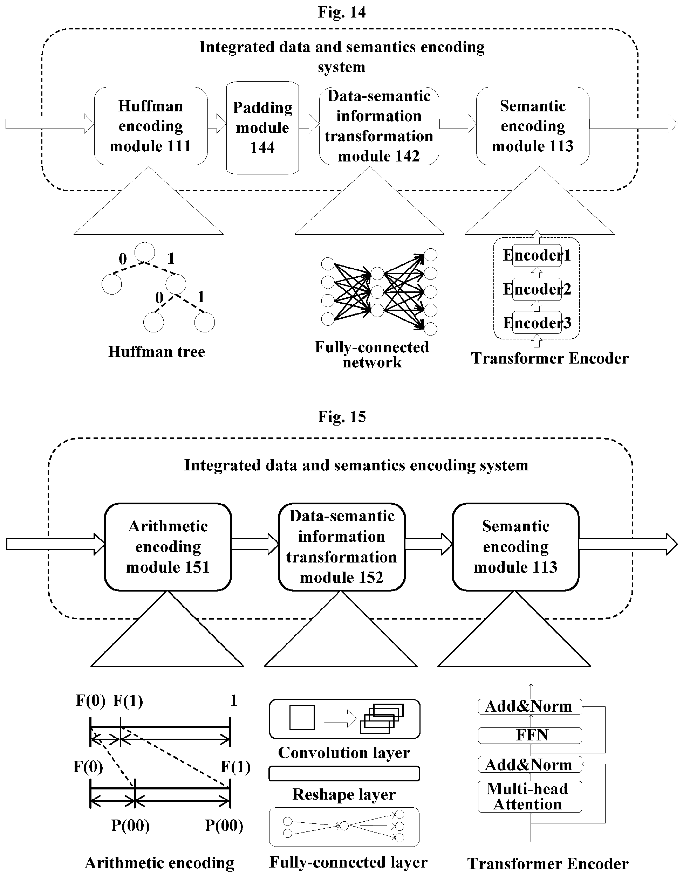

Fig. 14 is a schematic structural diagram of a system for integrating classical Huffman encoding and semantic encoding employing a padding mechanism according to some embodiments of the present disclosure. The system includes a Huffman encoding module 111, a padding module 144, and a data-semantic information transformation module 142 in front of the original semantic encoding module 113, thus achieving the integration of classical encoding and semantic encoding systems. The aforementioned modules can be one or more dedicated or general-purpose hardware modules, separate or integrated chips, memory, etc., with corresponding functions or technical features. The modules may alternatively be one or more embedded or non-embedded dedicated or general-purpose software, software modules, software codes, operating systems, or a combination of one or more hardware and software.

Exemplary Embodiment 4 is derived from Exemplary Embodiment 1, and the difference from Exemplary Embodiment 1 is the addition of a padding module in front of the data-semantic information transformation module.

The padding module may transform the codeword matrix **H** into a regular matrix with equal input lengths. The regular matrix is obtained by padding 0 at positions in the codeword matrix where elements did not originally exist. The shape of the zero-padding matrix is $[B,L,\max(H_{ij}) - H_{ij}]$, which is a matrix with an irregular shape.

The execution process of Exemplary Embodiment 4 is specifically described as follows.

Assuming the incoming message is **S,** which is composed of $B$ sentences each having the length of $L,$ and the length $L$ represents that there are $L$ words (in English) in each sentence, then the message **S** may be expressed as:

$$\mathbf{S} = \begin{bmatrix} w_{11} & w_{12} & ... & w_{1L} \\ w_{21} & w_{22} & ... & w_{2l} \\ ... & ... & ... & ... \\ w_{B1} & w_{B2} & ... & w_{BL} \end{bmatrix}$$

where $\{w_{ij}; i = 1,2,...,B.\ j = 1,2,...,L\}$ represents the $j$-th word of the $i$-th sentence.

The message matrix **S** first passes through the Huffman encoding module to obtain the Huffman codeword matrix **H,** with a shape of $[B,L,H_{ij}]$, where $H_{ij}$ represents the length of the Huffman codeword obtained by encoding the $j$-th word of the $i$-th sentence, and different $H_{ij}$ are of variable lengths. The longest Huffman codeword length is denoted as $\max(H_{ij})$.

To reduce system design complexity and storage space overhead, the Huffman codewords of variable lengths in the codeword matrix **H** are padded with 0 to obtain codewords of equal length $\max(H_{ij})$. The padded codeword matrix is denoted as **H'**, and has a dimension of $[B,L,\max(H_{ij})]$. The shape of the zero-padding matrix is $[B,L,\max(H_{ij}) - H_{ij}]$, which is a matrix with an irregular shape.

Subsequently, the codeword matrix **H'** is input into the data-semantic information transformation module, which consists of a single fully connected network with parameter size $[\max(H_{ij}), CorpusLen]$, and the data-semantic information transformation module outputs a vector matrix $\mathbf{A}_{code}$ with a size of $[B,L,CorpusLen]$.

Finally, the vector matrix $\mathbf{A}_{code}$ can be input into the semantic encoding module according to the schemes in Exemplary Embodiments 1, 2, or 3 of the present disclosure.

The innovation of Exemplary Embodiment 4 of the present disclosure at least includes: using the padding mechanism to eliminate the input restrictions of the data-semantic encoding module, which previously required regular matrix inputs. The padding mechanism allows irregular vector matrices to serve as the input of the data-semantic encoding module.

Exemplary Embodiment 5: Arithmetic encoding and semantic encoding integration scheme:
Exemplary Embodiment 5 involves a method for integrating arithmetic encoding with semantic encoding, allowing arithmetic encoding to be integrated with semantic encoding as well.

Fig. 15 is a schematic structural diagram of a system for integrating arithmetic encoding and semantic encoding according to some embodiments of the present disclosure. In the system, an arithmetic encoding module 151 and a data-semantic information transformation module 152 are added in front of the original semantic encoding module 113, thereby achieving the integration of classical encoding with semantic encoding. The aforementioned modules can be one or more dedicated or general-purpose hardware modules, separate or integrated chips, memory, etc., with corresponding functions or technical features. The modules may alternatively be one or more embedded or non-embedded dedicated or general-purpose software, software modules, software codes, operating systems, or a combination of one or more hardware and software.

The execution process of Exemplary Embodiment 5 is specifically described as follows.

Assuming the incoming message is **S,** which is composed of $B$ sentences each having the length of $L,$ and the length $L$ represents that there are $L$ words (in English) in each sentence, then the message **S** may be expressed as:

$$\mathbf{S} = \begin{bmatrix} w_{11} & w_{12} & \dots & w_{1L} \\ w_{21} & w_{22} & \dots & w_{2l} \\ \dots & \dots & \dots & \dots \\ w_{B1} & w_{B2} & \dots & w_{BL} \end{bmatrix}$$

The message matrix **S** first passes through the arithmetic encoding module, reducing the number of bits required to represent the data and using variable-length codewords to represent each sentence in the message matrix **S,** with lengths not being equal. The arithmetic encoded codeword matrix obtained is represented as **H** with a shape of [$B,H$,], where $H_i$ represents the length of the arithmetic encoded codeword obtained by encoding the $i$ -th sentence, and the longest length is denoted as max($H_i$).

Subsequently, the codeword matrix **H** passes through the data-semantic transformation module, and the data-semantic information transformation module establishes a mapping between arithmetic encoding and semantic encoding.

The establishment is divided into three steps. The first step is to pad all codeword vectors with 0 according to the longest length max($Hi$) in the codeword matrix **H** to obtain a new codeword matrix **H.** The second step is to use a convolutional layer with the number of layer channels being $L$ and a core size being $K \times K$ to change the size of the codeword matrix **H** passing through the convolutional layer into [$L,B,$ max($H_i$)] when the padding number $P$ and the step length $S$ of the codeword matrix **H** meet certain conditions. The third step is to swap the dimensions of the codeword matrix **H** and then process the swapped codeword matrix with a fully connected layer with parameter size related to a preset parameter $CorpusLen$ , so as to ultimately obtain a matrix $\mathbf{A}_{code}$ whose size is related to $CorpusLen$ .

Based on the above establishment steps, an exemplary implementation for establishing a mapping between arithmetic encoding and semantic encoding is described as follow.

In this module, first, all codeword vectors are padded with 0 according to the longest length max($H_i$) in the codeword matrix to obtain a new codeword matrix **H** with a size [$B$,max($H_i$)]. Then, the codeword matrix **H** pass through a convolutional layer with the number of layer channels being $L$ and a core size being 1*1. When the padding number $P$ and the step length $S$ meet the following relationship:

$$\begin{cases} \dfrac{P_H}{S_H - 1} = B \\ \dfrac{P_W}{S_W - 1} = \max(H_i) \end{cases}$$

where $P_H, S_H$ represents the padding number and the step length in the column direction, and $P_W$, $S_W$ represents the padding number and the step length in the row direction. The size of the codeword matrix **H** passing through the convolutional layer becomes [$L,B$,max($H_i$)] (equivalent to the imputable matrix in the above embodiments).

The first dimension and the second dimension of the codeword matrix whose size has become [$L,B$,max($H_i$)] are swapped, and the swapped codeword matrix passes through a fully connected layer with parameter size [max($H_i$), $CorpusLen$], so as to ultimately obtain an input matrix $\mathbf{A}_{code}$ of size $[B,L,CorpusLen]$ (equivalent to the vector matrix in the above embodiments).

The matrix $\mathbf{A}_{code}$ may be input into the semantic encoding module according to the schemes in Exemplary Embodiments 1, 2, and 3 of the present disclosure, which will not be repeated here.

The semantic encoding module may perform semantic encoding on the input message, thereby completing semantic communication.

The innovation of Exemplary Embodiment 5 of the present disclosure at least includes: incorporating arithmetic encoding into the data and semantics integrated encoding module based on the characteristics of convolutional neural networks.

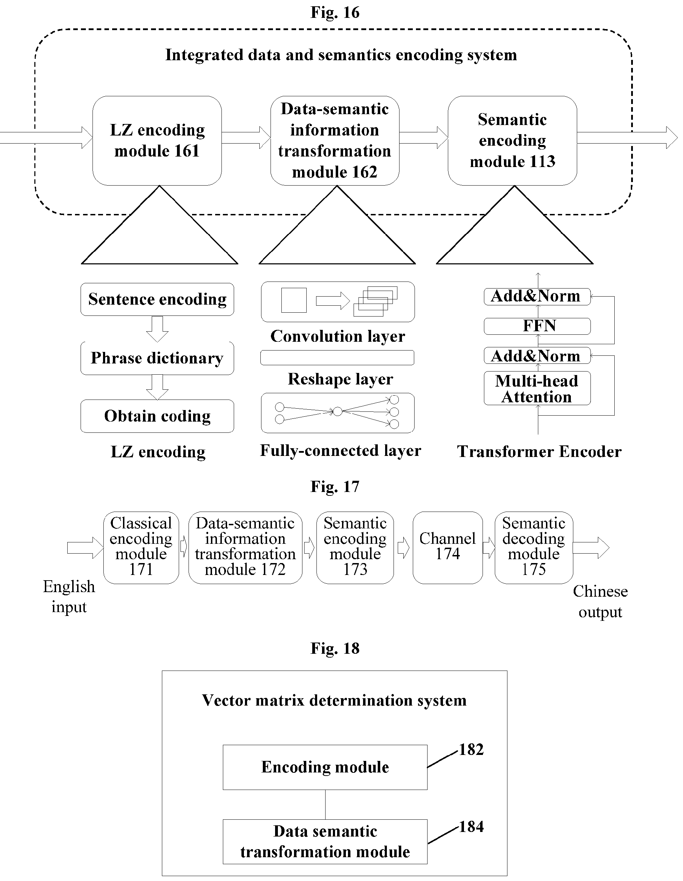

Exemplary Embodiment 6: LZ encoding and semantic encoding integration scheme:
Exemplary embodiment 6 of the present disclosure involves a method for integrating LZ encoding with semantic encoding, allowing LZ encoding to be integrated with semantic encoding. The system structure is shown in Fig. 16.

Fig. 16 is a schematic structural diagram of a system for integrating LZ encoding and semantic encoding according to some embodiments of the present disclosure. In the system, an LZ encoding module 161 and a data-semantic information transformation module 162 are added in front of the original semantic encoding module 113, thereby achieving the integration of classical encoding with semantic encoding. The aforementioned modules can be one or more dedicated or general-purpose hardware modules, separate or integrated chips, memory, etc., with corresponding functions or technical features. The modules may alternatively be one or more embedded or non-embedded dedicated or general-purpose software, software modules, software codes, operating systems, or a combination of one or more hardware and software.

Exemplary Embodiment 6 is derived from Exemplary Embodiment 5, and the difference from Exemplary Embodiment 5 lies in the replacement of the arithmetic encoding module with the LZ encoding module.

The message matrix first passes through the LZ encoding module, reducing the number of bits required to represent the data. The LZ encoding creates a new dictionary and encodes different sentences to obtain codewords with different encoding lengths. The codeword matrix obtained after LZ encoding is represented as **H,** with a shape $[B,H_i]$, where $H_i$ represents the length of the LZ encoding codeword obtained by encoding the $i$-th sentence, and the longest length is denoted as $\max(H_i)$.

The rest modules are similar to Exemplary Embodiment 5.

The execution process of the LZ encoding and semantic encoding integration method is specifically described as follows.

Assuming the input message is S, composed of $B$ sentences each having the length of $L$, and the length $L$ represents that there are $L$ words (in English) in each sentence, then the message S may be expressed as:

$$\mathbf{S} = \begin{bmatrix} w_{11} & w_{12} & ... & w_{1L} \\ w_{21} & w_{22} & ... & w_{2l} \\ ... & ... & ... & ... \\ w_{B1} & w_{B2} & ... & w_{BL} \end{bmatrix}$$

The message matrix **S** first passes through the LZ encoding module. LZ encoding creates a new dictionary and encodes different sentences to obtain codewords with different encoding lengths. The codeword matrix obtained after LZ encoding is represented as **H,** with a shape $[B,H_i]$, where $H_i$ represents the length of the LZ encoding codeword obtained by encoding the $i$-th sentence, and the longest length is denoted as $\max(H_i)$.

The subsequent encoding process is consistent with the process described in Exemplary Embodiment 5 of the present disclosure, which will not be repeated here.

The innovation of Exemplary Embodiment 6 of the present disclosure at least includes: incorporating LZ encoding into the data and semantics integrated encoding module based on the characteristics of convolutional neural networks.

Exemplary Embodiment 7: Semantic encoding and decoding scheme for multiple languages:
Exemplary Embodiment 7 involves a method for semantic encoding and decoding of multiple languages. Exemplary Embodiment 7 describes a semantic encoding and decoding device for multiple languages, taking the transmission of English and the reception of Chinese as an example.

Based on the aforementioned model, by changing the training method of the semantic encoder and decoder, a semantic encoding and decoding scheme for multiple languages can be realized. The key idea behind the integration of classical encoding and semantic encoding is the belief that natural languages encoded in sequence can still retain their semantic correlation information in their binary sequences. In fact, numbers themselves are also a form of natural language, and the encoded numbers still retain correlation information. For example, for someone who knows Chinese but does not understand English at all, translating Chinese into English is essentially encoding Chinese with 26 English letters. Although the form is different, it still retains the unique correlation information of natural language. Encoding Chinese with binary sequences is the same.

Based on the above principle, when the training data at two ends of the semantic communication system is changed, data encoding may vary due to different forms of natural languages, but semantic encoding will still be able to extract the inherent semantic correlation information even when different encoding methods are adopted.

Exemplary Embodiment 7 describes a semantic encoding and decoding scheme for multiple languages, taking the transmission of English and the reception of Chinese as an example. The system structure of this scheme is shown in Fig. 17.

Fig. 17 is a schematic structural diagram of a multi-language semantic encoding and decoding system according to some embodiments of the present disclosure. The system includes: a classical encoding module 171 (including but not limited to Huffman encoding, arithmetic encoding, LZ encoding as described in the above embodiments), a data-semantic information transformation module 172 (including but not limited to any data-semantic information transformation module described in the above embodiments), a semantic encoding module 173 (equivalent to any semantic encoding module described in the above embodiments), a channel 174, and a semantic decoding module 175. The aforementioned modules can be one or more dedicated or general-purpose hardware modules, separate or integrated chips, memory, etc., with corresponding functions or technical features. The modules may alternatively be one or more embedded or non-embedded dedicated or general-purpose software, software modules, software codes, operating systems, or a combination of one or more hardware and software.

Further, based on the system shown in Fig. 17, the English input refers to the input of English as the source during the communication process. Correspondingly, during the training process of the system, English is used as the input corpora.

The classical encoding module refers to a Huffman encoding module, an arithmetic encoding module, or an LZ encoding module, where the classical encoding module stores data encoding information.

The data-semantic information transformation module refers to the data (encoding)-semantic encoding mapping module in Exemplary Embodiments 1-6, where different structures determine the design complexity of the overall system, and the data-semantic information transformation module stores the mapping relationship between data encoding and semantic encoding.

The semantic encoding module refers to a semantic correlation information extractor built with a Transformer Encoder, and can store semantic encoding information of English.

The channel refers to a normal wireless or wired communication channel.

The semantic decoding module refers to a semantic correlation information provider built with a Transformer Decoder, and can store semantic decoding information of Chinese.

The Chinese output refers to the reception of Chinese with the same semantics as the English sent from the source end during the communication process at the destination end.

The innovation of Exemplary Embodiment 7 of the present disclosure at least includes: based on the method for integrating classical encoding and semantic encoding, bilingual corpora can be used during the system training to implement a semantic communication system for multiple languages.

It should be noted that the above Exemplary Embodiments 1 to 7 can be implemented alone or in combination with each other, which is not limited in the present disclosure.

The above exemplary embodiments of the present disclosure are innovative in at least the following aspects:

1) A semantic-data transformation module that integrates Huffman encoding is provided. The semantic-data transformation module is based on a fully connected network, processes variable-length classical codewords, completes a mapping between data redundancy and semantic redundancy, and outputs a One-Hot vector required by the semantic encoding module.

2) An improvement on the Embedding in the semantic encoder is proposed. Based on the principle of Embedding, the Embedding layer can be replaced by a fully connected layer, thereby removing the format restrictions on the input data of the semantic encoding module.

3) A creation manner of "Many-Hot" vectors is proposed. Based on the principle of One-Hot vectors and the relationship between classical encoding data redundancy and semantic encoding semantic redundancy, a grouping method is utilized to implement One-Hot vectors respectively, and the One-Hot vectors are finally connected to obtain a "Many-Hot" vector, which can better reflect the relationship between data redundancy and semantic redundancy.

4) A regular processing of variable-length codewords is proposed based on a padding mechanism. Based on the padding mechanism and a principle of Softmax operation, variable-length codewords are enabled to be directly input into the semantic-data transformation module, removing the restrictions on the input data format for the semantic-data transformation module.

5) A semantic-data transformation module that integrates arithmetic encoding and LZ encoding is proposed. This semantic-data transformation module is based on a convolutional neural network, processes variable-length classical codewords, completes the mapping between data redundancy and semantic redundancy, and outputs the One-Hot vectors required by the semantic encoding module.

6) A multilingual transmission system based on classical encoding schemes is proposed. Based on the basic principles of Transformer and the nature of semantic correlation information, different languages may be used during the training of the data and semantic integration module, thereby realizing a multilingual semantic communication system.

In summary, the exemplary embodiments of the present disclosure propose an encoding method that integrates data and semantics for multiple languages. This method can receive variable-length codewords from classical source encoding systems and further compress the variable-length codewords using the semantic redundancy contained in contextual information, achieving joint manipulation of data redundancy and semantic redundancy, and integrating classical source encoding systems with semantic encoding systems. The semantic decoding module at the receiving end may remain unchanged, reducing the overall design complexity of the system.

The embodiments of the present disclosure further provide a vector matrix determination system. The vector matrix determination system is configured to implement the foregoing embodiments and exemplary implementations, and what has been described will not be elaborated. The term "module", as used hereinafter, is a combination of software and/or hardware capable of realizing a predetermined function. Although the device described in the following embodiments is preferably implemented by software, implementation of hardware or a combination of software and hardware is also possible and conceived.

Fig. 18 is a block diagram of a vector matrix determination system according to some embodiments of the present disclosure. As shown in Fig. 18, the vector matrix determination system includes:

an encoding module 182, configured to encode a message to be transmitted into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix; and

a data semantic transformation module 184, coupled with the encoding module and configured to transform the codeword matrix through a group of fully-connected networks to obtain a vector matrix in which codewords have the same codeword lengths.

By means of the described vector matrix determination system, a message to be transmitted is encoded into a codeword matrix; and the codeword matrix is transformed through a group of fully-connected networks to obtain a vector matrix in which codewords have the same codeword lengths. That is to say, by encoding a message to be transmitted into a three-dimensional codeword matrix, and transforming the obtained codeword matrix into a vector matrix in which codewords have the same codeword lengths, the technical problem that a semantic communication systems in the related art does not involve classical data encoding and requires transmitted sentence lengths to be identical, leading to the inability to integrate the semantic communication system with classical communication is solved. The technical effect of integrating classical encoding with semantic encoding of a semantic communication system of the related art is achieved, and by integrating the classical encoding and the semantic encoding, to-be-transmitted sentences with different lengths are able to be processed.

In an exemplary embodiment, the vector matrix determination system further includes: a semantic encoding module, coupled with the data semantic transformation module and configured to replace an embedding layer of the semantic encoding module with a first fully-connected network, and receive the vector matrix through the first fully-connected network.

In an exemplary embodiment, the group of fully-connected networks includes a plurality of fully-connected networks having different input lengths but the same output lengths, a size of a second dimension of two-dimensional parameters of the plurality of fully-connected networks is related to a number of words in a word list corresponding to a natural language used when training the plurality of fully-connected networks, and the vector matrix serves as an input of a semantic encoding module, wherein the vector matrix is a three-dimensional vector matrix.

In an exemplary embodiment, the encoding module 182 is further configured to perform at least one of: encoding the message to be transmitted into the codeword matrix by using a Huffman encoding algorithm; encoding the message to be transmitted into the codeword matrix by using an arithmetic encoding algorithm; encoding the message to be transmitted into the codeword matrix by using a Lempel-Ziv (LZ) encoding algorithm; encoding the message to be transmitted into the codeword matrix by using a Huffman encoding algorithm, and truncating the codeword matrix according to a target length to form a lossy encoded codeword matrix.

That is, the message to be transmitted is encoded into the codeword matrix by using a classical encoding algorithm, where the classical encoding algorithm includes, but is not limited to, a Huffman encoding algorithm, an arithmetic encoding algorithm, and an LZ encoding algorithm. In some exemplary implementations, the codeword matrix obtained by using the Huffman encoding algorithm may further be truncated according to a certain length (i.e., the target length), so as to form a lossy encoded codeword matrix.

In an exemplary embodiment, the data semantic transformation module 184 is further configured to obtain a codeword length of each codeword in the codeword matrix; and determine the codeword length as a size of a first dimension of the two-dimensional parameters of a fully-connected network corresponding to the each codeword.

After the message to be transmitted is input to a classical encoding module adopting the classical encoding algorithm, the classical encoding module transforms and outputs the message to be transmitted as a codeword matrix. In general, the output codeword matrix includes a plurality of codewords, and the codeword lengths of the codewords in the output codeword matrix are not equal lengths. However, it is also possible to obtain a codeword matrix including a plurality of codewords having the same codeword length, or obtain a codeword matrix only having one codeword.

In an exemplary embodiment of the present disclosure, a classical encoding module is merged with a semantic encoding module of a semantic communication system, and a data-semantic information transformation module is used to transform a codeword matrix output by the classical encoding module into a vector matrix that can be input to the classical encoding module. In some exemplary implementations, the data-semantic information transformation module may include a group of fully-connected networks, and is configured to transform the codeword matrix output by the classical encoding module into a vector matrix in which codewords have the same codeword lengths, so that the vector matrix can be input into the semantic communication system conveniently. Specifically, the group of fully-connected networks includes a plurality of fully-connected networks, and the number of the plurality of fully-connected networks may be the same as the number of codewords in the codeword matrix. A size of a first dimension of two-dimensional parameters of each fully-connected network in the plurality of fully-connected networks is equal to a codeword length of a codeword to be processed corresponding to each fully-connected network. For example, the size of the first dimension of the fully-connected network corresponding to the codeword with the codeword length of 1 is 1, and the size of the first dimension of the fully-connected network corresponding to the codeword with the codeword length of 2 is 2, and so on.

In an exemplary embodiment, the data semantic transformation module 184 is further configured to input the each codeword in the codeword matrix into the fully-connected network corresponding to the each codeword, and determine a vector **A** in the vector matrix corresponding to the each codeword by using the following formula:

$$\mathbf{A} = \mathbf{W}^i h + b^i,$$

wherein $h$ represents the each codeword in the codeword matrix, and $W^i$ and $b^i$ represent the two-dimensional parameters of a fully-connected network corresponding to an i-th codeword in the codeword matrix, wherein the size of the first dimension of $\mathbf{W}^i$ and $b^i$ is the codeword length of the i-th codeword; and obtain the vector matrix according to a position of the each codeword in the codeword matrix and the vector **A** corresponding to the each codeword.

It can be understood that the fully-connected network transforms the codeword in the codeword matrix into the vector in the vector matrix by means of the described formula. Specifically, each codeword in the codeword matrix is input into a corresponding fully-connected network, and the codeword is transformed by means of the described formula to obtain the vector corresponding to the codeword, After transforming all the codewords in the codeword matrix into corresponding vectors, the obtained vectors are combined into the vector matrix according to the position of each codeword in the codeword matrix.

The size of the second-dimension of the two-dimensional parameters $\mathbf{W}^i$ and $b^i$ in the above formula are both related to a size of a word list used during training, and the size of the word list used during training is equal to the number of words in the word list corresponding to the natural language used during training. In an exemplary embodiment, if the natural language used during training is Chinese and 7000 words exist in the corresponding word list, the size of the second dimension of the two-dimensional parameters of the plurality of fully-connected networks included in the group of fully-connected network is 7000. It should be noted that the obtained vector matrix is a three-dimensional vector matrix with fixed dimensions, and a size of the third dimension of the vector matrix is related to the size of the word list used during training, wherein the size of the word list used in training is the number of words in the word list corresponding to the natural language used in training, for example, in a case where the size of the second dimension of the two-dimensional parameters of the group of fully-connected networks is 7000, the size of the third dimension of the vector matrix is 7000.

It should be noted that, the foregoing value "7000" is only an example, and is not used to limit the present disclosure. In addition, it can be deduced by analogy that a natural language used during training is not limited to Chinese, and the size of the word list used during training is also not limited to 7000 words, but is related to an actual size of the word list corresponding to the natural language used during training.

An Embedding layer of the semantic encoding module requires an input vector in a One-Hot form (referred to as a One-Hot vector). It should be noted that the One-Hot vector is a method for transforming discrete, categorical data into continuous vector representations. In the One-Hot vector, each category is encoded into a vector with only one dimension being set to 1 and all other dimensions being set to 0. The use of the One-Hot vector facilitates the transformation of any number of different labels into dense and low-dimensional vectors with fixed lengths, with these vectors being independent of each other and having no inherent relationships. Therefore, in many machine learning algorithms, input data is often encoded into the One-hot vector form for processing.

Thus, after transforming the codeword matrix into the vector matrix, the following alternative operations may be performed.

1) One alternative is to further transform the vector matrix into an input vector in a One-Hot form.

In an exemplary embodiment, the data semantic transformation module 184 is further configured to obtain a probability vector corresponding to each third dimension vector of the vector matrix; determine a target vector according to the probability vector, wherein the target vector is a vector with a maximum element of the each third dimension vector being set to a first value; and combine a plurality of target vectors into a target matrix.

In an exemplary embodiment, the data semantic transformation module 184 is further configured to determine, according to the probability vector, noise data corresponding to the each third dimension vector; and determine the target vector according to the noise data and the probability vector, wherein the noise data is used for ensuring that the target vector is not a constant value.

It is understandable that dividing the vector matrix into multiple probability vectors according to the third dimension essentially highlights a maximum value in each probability vector, i.e., a probability value of the probability vector corresponding to the maximum value in each third-dimension vector is the largest among probability values of all probability vectors corresponding to the third-dimension vector..

In order to ensure that the target vector is not a constant value, thus allowing for gradient back propagation, re-parameterization techniques can be employed.

In an exemplary embodiment, Gumbel noise is added to the probability vector, specifically including: determining corresponding noise data based on the third-dimension vector, i.e., calculating noise data corresponding to each vector element in the third-dimension vector; adding each probability element in the obtained probability vector to its corresponding noise data, so as to obtain a target probability vector (i.e., the target vector in the aforementioned embodiment); and combining all target probability vectors to obtain the target matrix, i.e., the One-Hot form input matrix, and inputting the target matrix to the Embedding layer of the semantic encoding module.

2) Another alternative is to replace the Embedding layer in the semantic encoding module so as to remove the restriction of the input vector in the One-Hot form required by the Embedding layer.

In an exemplary embodiment, the data semantic transformation module 184 is further configured to directly input the vector matrix into a first fully-connected network of a semantic encoding module, wherein a size of a first dimension of the two-dimensional parameter of the first fully-connected network is related to the number of the words in the word list.

In an exemplary embodiment of the present disclosure, a size of a first dimension of the two-dimensional parameters of a fully-connected network replacing the Embedding layer is the same as a size of the third dimension of the target vector. In this way, the vector matrix may be directly input into the semantic encoding module, thereby avoiding the need of transforming the vector matrix into the input vector in the One-Hot form.

In an exemplary embodiment, the data semantic transformation module 184 is further configured to divide the vector matrix in a direction of a third dimension of the vector matrix, so as to obtain multiple sub-vector matrices; and transform the multiple sub-vector matrices into multiple sub-target matrices, and determining a target matrix according to the multiple sub-target matrices.

A feasible solution for dividing the vector matrix in the direction of the third dimension of the vector matrix includes: dividing the vector matrix according to a maximum codeword length of the codeword matrix corresponding to the vector matrix, wherein the number of the multiple sub-vector matrices (i.e., the number of sub-vector matrices into which the vector matrix is divided) is related to the codeword length in the corresponding codeword matrix. A more specific solution is that the number of sub-vector matrices into which the vector matrix is divided is related to a value obtained by subtracting the codeword length of the codeword corresponding to the vector in the vector matrix from the maximum codeword length. For example, if the codeword length of the codeword corresponding to a certain vector in the vector matrix is 2, and the maximum codeword length is 8, then the number of the divided multiple sub-vector matrices is equal to 8-2=6. If the vectors of the vector matrix cannot be equally divided according to the number of sub-vector matrices into which the vector matrix is divided, the remaining elements may be discarded, or the group of elements that cannot be equally divided is taken as the last group.

In an exemplary embodiment, the data semantic transformation module 184 is further configured to obtain a maximum codeword length of the codeword matrix; pad target positions in the codeword matrix with second values according to the maximum codeword length, so as to obtain a padded codeword matrix in which the codeword lengths of all the codewords are equal to the maximum codeword length; and transform all the codewords in the padded codeword matrix through the group of fully-connected networks to obtain the vector matrix in which the codewords have the same codeword lengths.

In some exemplary implementations, the codeword matrix is first padded according to the maximum codeword length of the codeword matrix, so as to obtain a padded codeword matrix in which all the codewords have the same codeword length.

For example, it is assumed that the message to be transmitted is **S**, the message **S** is formed by $B$ sentences each having a length of $L$, and the length $L$ indicates that there are $L$ words in the corresponding sentence. In a case where a classical encoding module is a Huffman encoding module, the codeword matrix output by the Huffman encoding module is a three-dimensional codeword matrix with a dimension of $[B,L,H_{ij}]$, where $H_{ij}$ denotes a Huffman codeword length obtained by encoding the $j$-th word of the $i$-th sentence, the Huffman codeword lengths are unequal lengths with a maximum codeword length being denoted as $\max(H_{ij})$. In a case where the codeword matrix is padded with second values, a padded codeword matrix with the same codeword length can be obtained, and the padded codeword matrix has a dimension of $[B,L,\max(H_{ij})]$.

In addition, a data-semantic transformation module using the padded codeword matrix as an input may transform the padded codeword matrix into the vector matrix by using only a two-dimensional fully-connected network with a parameter size $[\max(H_{ij}),CorpusLen]$. It should be noted that $CorpusLen$ is related to a size of a word list used during training, and the size of the word list used during training is equal to the number of words in the word list corresponding to a natural language used during training. In an exemplary embodiment of the present disclosure, the structure of the data-semantic transformation module may be made simpler.

In an exemplary embodiment, the data semantic transformation module 184 is further configured to, in a case where the message to be transmitted is encoded by using an arithmetic encoding algorithm or a Lempel-Ziv (LZ) encoding algorithm, obtain a two-dimensional codeword matrix corresponding to the arithmetic encoding algorithm or the LZ encoding algorithm; obtain a three-dimensional codeword matrix corresponding to the two-dimensional codeword matrix, and swap a first dimension and a second dimension of the three-dimensional codeword matrix to obtain an inputtable matrix, wherein a size of a third dimension of the inputtable matrix is a maximum codeword length of the codeword matrix; determine a second fully-connected network in which a size of a first dimension of the two-dimensional parameters is the maximum codeword length and a size of the second dimension of the two-dimensional parameters is related to the number of the words in the word list; and transform each codeword in the inputtable matrix through the second fully-connected network, so as to obtain the vector matrix in which the codewords have the same codeword lengths.

In a case where the classical encoding module adopts an arithmetic encoding algorithm or an LZ encoding algorithm, the codeword matrix obtained after transforming the message to be transmitted is a two-dimensional codeword matrix. Further, the data-semantic information transformation module corresponding to the arithmetic encoding algorithm or the LZ encoding algorithm may be selected to be a data-semantic information transformation module formed by a convolution layer, a Reshape layer, and a fully-connected layer (equivalent to the second fully-connected network in the above embodiments).

Therefore, the operation of obtaining the three-dimensional codeword matrix corresponding to the two-dimensional codeword matrix includes: in a case where the two-dimensional codeword matrix has a shape of $[B,H_i]$, where $H_i$ denotes an arithmetic encoding codeword length obtained by encoding the $i$-th sentence, and a longest length is denoted as $\max(H_i)$, padding the two-dimensional codeword matrix to obtain a padded two-dimensional codeword matrix whose size is $[B,\max(H_i)]$; and obtaining the three-dimensional codeword matrix according to the padded two-dimensional codeword matrix when a certain condition is satisfied.

In some exemplary implementations, the operation of obtaining the three-dimensional codeword matrix according to the padded two-dimensional codeword matrix when the certain condition is satisfied includes: processing the padded two-dimensional codeword matrix through a convolution layer with the number of layer channels being $L$ and a core size being 1*1, in a case where a padding number P and a step length S of the convolution layer satisfy the following relationship:

$$\begin{cases} \dfrac{P_H}{S_H - 1} = B \\ \dfrac{P_W}{S_W - 1} = \max(H_i) \end{cases},$$

wherein $P_H$, $S_H$ represents the padding number and the step length in a column direction, and $P_W$, $S_W$ represents the padding number and the step length in a row direction; and obtaining a three-dimensional codeword matrix corresponding to the padded two-dimensional codeword matrix through the convolution layer, wherein the three-dimensional codeword matrix has a dimension of $[L,B,\max(H_i)]$.

Further, a first dimension and a second dimension of the obtained three-dimensional codeword matrix are swapped to obtain an inputtable matrix, and the inputtable matrix is input to a second fully-connected network with a parameter size of $[\max(H_i),CorpusLen]$, so as to obtain a vector matrix with a dimension of *[B,L,CorpusLen]*. For a solution of inputting the vector matrix to the semantic encoding module, reference may be made to other embodiments of the present disclosure, and details are not repeatedly described herein.

In the exemplary embodiment described above, the first value is a positive number, and the second value is a value smaller than the first value. For example, in a case where the first value is set to be a positive number of 2, the second value may take a value smaller than 2.

Through the description of the foregoing embodiments, those having ordinary skill in the art may clearly understand that the vector matrix determination method according to the foregoing embodiments may be implemented by software in addition to a necessary universal hardware platform, and definitely may also be implemented by hardware. However, in many cases, the former is a preferred implementation. Based on such understanding, the essence of the technical solutions of the embodiments of the present disclosure or the part contributing to the related art may be embodied in the form of a software product. The computer software product is stored in a readable storage medium (such as a Read-Only Memory (ROM)/Random Access Memory (RAM), a magnetic disk, and an optical disk), and includes several instructions for instructing a terminal device (which may be a mobile phone), a computer, a server, a network device, or the like.

In an exemplary embodiment, the computer readable storage medium may include, but is not limited to, any medium that can store a computer program, such as a Universal Serial Bus (USB) flash drive, a Read-Only Memory (ROM), a Random Access Memory (RAM), a removable hard disk, a magnetic disk, or an optical disc.

For specific examples in this embodiment, reference may be made to the examples described in the foregoing embodiments and exemplary embodiments, and details are not repeatedly described in this embodiment.

Embodiments of the present disclosure further provide an electronic device, including a memory and a processor. The memory stores a computer program. The processor is configured to run the computer program to execute operations in any one of the method embodiments.

In some exemplary implementations of the embodiment, the processor may be arranged to execute the following operations S1 and S2 when running the computer program.

In operation S1, a message to be transmitted is encoded into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix.

In operation S2, the codeword matrix is transformed through a group of fully-connected networks to obtain a vector matrix in which codewords have the same codeword lengths.

In an exemplary embodiment, the electronic device may further include a transmission device and an input/output device, wherein the transmission device is connected to the processor, and the input/output device is connected to the processor.

In an exemplary implementation of the embodiment, the above electronic device may be further configured to execute the following operations: S1, a message to be transmitted is encoded into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix; and S2, the codeword matrix is transformed through a group of fully-connected networks to obtain a vector matrix in which codewords have the same codeword lengths.

For specific examples in this embodiment, reference may be made to the examples described in the foregoing embodiments and exemplary embodiments, and details are not repeatedly described in this embodiment.

Obviously, those having ordinary skill in the art should understand that each module or each operation of the present disclosure can be implemented by a universal computing device. The modules or operations may be centralized on a single computing device or distributed on a network composed of a plurality of computing devices. The modules or operations may be implemented by program codes executable by a computing apparatus, and thus can be stored in a storage apparatus and executed by the computing apparatus, Furthermore, in some cases, the shown or described operations may be executed in an order different from that described here, or they are made into integrated circuit modules respectively, or a plurality of modules or operations therein are made into a single integrated circuit module for implementation. As such, the present disclosure is not limited to any particular hardware and software combination.

The foregoing descriptions are merely exemplary embodiments of the present disclosure, but are not intended to limit the present disclosure. For those having ordinary skill in the art, the present disclosure may have various modifications and variations. Any modifications, equivalent replacements, improvements and the like made within the principle of the present disclosure shall fall within the scope of protection of the present disclosure.

**Claims**

1. A vector matrix determination method, comprising:

   encoding a message to be transmitted into a codeword matrix, wherein the codeword matrix comprises a single codeword or a plurality of codewords, the codeword matrix comprises a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix; and
   transforming the codeword matrix through a group of fully-connected networks to obtain a vector matrix in which codewords have the same codeword lengths.

2. The vector matrix determination method according to claim 1, wherein
   the group of fully-connected networks comprises a plurality of fully-connected networks having different input lengths but the same output lengths, a size of a second dimension of two-dimensional parameters of the plurality of fully-connected networks is related to a number of words in a word list corresponding to a natural language used when training the plurality of fully-connected networks, and the vector matrix serves as an input of a semantic encoding module, wherein the vector matrix is a three-dimensional vector matrix.

3. The vector matrix determination method according to claim 2, wherein before the transforming the codeword matrix through a group of fully-connected networks to obtain a vector matrix in which codewords have the same codeword lengths, the vector matrix determination method further comprises:

obtaining a codeword length of each codeword in the codeword matrix; and
determining the codeword length as a size of a first dimension of the two-dimensional parameters of a fully-connected network corresponding to the each codeword.

4. The vector matrix determination method according to claim 3, wherein the transforming the codeword matrix through a group of fully-connected networks to obtain a vector matrix in which codewords have the same codeword lengths comprises:

inputting the each codeword in the codeword matrix into the fully-connected network corresponding to the each codeword, and determining a vector A in the vector matrix corresponding to the each codeword by using the following formula:

$$\mathbf{A}=\mathbf{W}^{i}h+b^{i},$$

wherein $h$ represents the each codeword in the codeword matrix, and $\mathbf{W}^{i}$ and $b^{i}$ represent the two-dimensional parameters of a fully-connected network corresponding to an i-th codeword in the codeword matrix, wherein the size of the first dimension of $\mathbf{W}^{i}$ and $b^{i}$ is the codeword length of the i-th codeword; and
obtaining the vector matrix according to a position of the each codeword in the codeword matrix and the vector $\mathbf{A}$ corresponding to the each codeword.

5. The vector matrix determination method according to claim 1, wherein after the transforming the codeword matrix through a group of fully-connected networks to obtain a vector matrix in which codewords have the same codeword lengths, the vector matrix determination method further comprises:

obtaining a probability vector corresponding to each third dimension vector of the vector matrix;
determining a target vector according to the probability vector, wherein the target vector is a vector with a maximum element of the each third dimension vector being set to a first value; and
combining a plurality of target vectors into a target matrix.

6. The vector matrix determination method according to claim 5, wherein the determining a target vector according to the probability vector comprises:

determining, according to the probability vector, noise data corresponding to the each third dimension vector; and
determining the target vector according to the noise data and the probability vector, wherein the noise data is used for ensuring that the target vector is not a constant value.

7. The vector matrix determination method according to claim 2, wherein after the transforming the codeword matrix through a group of fully-connected networks to obtain a vector matrix in which codewords have the same codeword lengths, the vector matrix determination method further comprises:
directly inputting the vector matrix into a first fully-connected network of a semantic encoding module, wherein a size of a first dimension of the two-dimensional parameter of the first fully-connected network is related to the number of the words in the word list.

8. The vector matrix determination method according to claim 1, wherein after the transforming the codeword matrix through a group of fully-connected networks to obtain a vector matrix in which codewords have the same codeword lengths, the vector matrix determination method further comprises:

dividing the vector matrix in a direction of a third dimension of the vector matrix, so as to obtain multiple sub-vector matrices; and

transforming the multiple sub-vector matrices into multiple sub-target matrices, and determining a target matrix according to the multiple sub-target matrices.

9. The vector matrix determination method according to claim 1, wherein the transforming the codeword matrix through a group of fully-connected networks to obtain a vector matrix in which codewords have the same codeword lengths comprises:

obtaining a maximum codeword length of the codeword matrix;
padding target positions in the codeword matrix with second values according to the maximum codeword length, so as to obtain a padded codeword matrix in which the codeword lengths of all the codewords are equal to the maximum codeword length; and
transforming all the codewords in the padded codeword matrix through the group of fully-connected networks to obtain the vector matrix in which the codewords have the same codeword lengths.

10. The vector matrix determination method according to claim 2, comprising:

in a case where the message to be transmitted is encoded by using an arithmetic encoding algorithm or a Lempel-Ziv, LZ, encoding algorithm, obtaining a two-dimensional codeword matrix corresponding to the arithmetic encoding algorithm or the LZ encoding algorithm;
obtaining a three-dimensional codeword matrix corresponding to the two-dimensional codeword matrix, and swapping a first dimension and a second dimension of the three-dimensional codeword matrix to obtain an inputtable matrix, wherein a size of a third dimension of the inputtable matrix is a maximum codeword length of the codeword matrix; and
determining a second fully-connected network in which a size of a first dimension of the two-dimensional parameters is the maximum codeword length and a size of the second dimension of the two-dimensional parameters is related to the number of the words in the word list; and transforming each codeword in the inputtable matrix through the second fully-connected network, so as to obtain the vector matrix in which the codewords have the same codeword lengths.

11. The vector matrix determination method according to claim 1, wherein the encoding a message to be transmitted into a codeword matrix comprises at least one of:

encoding the message to be transmitted into the codeword matrix by using a Huffman encoding algorithm;
encoding the message to be transmitted into the codeword matrix by using an arithmetic encoding algorithm;
encoding the message to be transmitted into the codeword matrix by using a Lempel-Ziv, LZ, encoding algorithm;
encoding the message to be transmitted into the codeword matrix by using a Huffman encoding algorithm, and truncating the codeword matrix according to a target length to form a lossy encoded codeword matrix.

12. The vector matrix determination method according to claim 5 or 9, wherein the first value is a positive number, and the second value is a value smaller than the first value.

13. A vector matrix determination system, comprising:

an encoding module, configured to encode a message to be transmitted into a codeword matrix, wherein the codeword matrix comprises a single codeword or a plurality of codewords, the codeword matrix comprises a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix; and
a data semantic transformation module, coupled with the encoding module and configured to transform the codeword matrix through a group of fully-connected networks to obtain a vector matrix in which codewords have the same codeword lengths.

14. The vector matrix determination system according to claim 13, further comprising: a semantic encoding module, coupled with the data semantic transformation module and whose embedding layer is replaced with a first fully-connected network, and configured to receive the vector matrix through the first fully-connected network.

15. A computer readable storage medium, wherein the computer readable storage medium stores a computer program, and the computer program is configured to execute the vector matrix determination method according to any one of claims 1 to 12 when running.

16. An electronic device, comprising a memory and a processor, wherein the memory stores a computer program, and the processor is configured to execute the vector matrix determination method according to any one of claims 1 to 12 by running the computer program.

**Fig. 1**

**Fig. 2**

**Fig. 3**

Encoding a message to be transmitted into a codeword matrix, wherein the codeword matrix includes a single codeword or a plurality of codewords, the codeword matrix includes a regular codeword matrix and an irregular codeword matrix, codeword lengths of codewords in the regular codeword matrix are the same, codeword lengths of codewords in the irregular codeword matrix are different, and the codeword matrix is a three-dimensional codeword matrix ⟋ S302

Transforming the codeword matrix through a group of fully-connected networks to obtain a vector matrix in which codewords have the same codeword lengths ⟋ S304

**Fig. 4**

**Fig. 5**

Data encoding space

**Fig. 6**

Semantic space

**Fig. 7**

Semantic encoding space
considering semantic
correlation information

**Fig. 8**

Semantic encoding space
considering most
efficient physical carriers

**Fig. 9**

Semantic encoding space
consider actual cases

**Fig. 10**

$\lambda\llbracket\ \delta_D\rrbracket$

S(D)

$cor\llbracket\ \delta_D\rrbracket$

**Fig. 11**

Integrated data and semantics encoding system

| Huffman encoding module 111 | Data-semantic information transformation module 112 | Semantic encoding module 113 |

0    1

0    1

Encoder1

Encoder2

Encoder3

Huffman tree

Group of fully-connected networks

Transformer Encoder

**Fig. 12**

**Integrated data and semantics encoding system**

Huffman encoding module 111 → Data-semantic information transformation module 112 → Semantic encoding module 123

Huffman tree

Group of fully-connected networks

Fully-connected layer → Replacing → Embedding

Transformer Encoder

**Fig. 13**

**Integrated data and semantics encoding system**

Huffman encoding module 111 → Data-semantic information transformation module 112 → "Many Hot" vector transformation module 134 → Semantic encoding module 113

Huffman tree

Group of fully-connected networks

One-Hot → Connect → "Many-Hot"

Vector transformation

Encoder1
Encoder2
Encoder3

Transformer Encoder

**Fig. 14**

Integrated data and semantics encoding
system

| Huffman encoding module 111 | Padding module 144 | Data-semantic information transformation module 142 | Semantic encoding module 113 |

0   1

0   1

**Huffman tree**

**Fully-connected network**

Encoder1

Encoder2

Encoder3

**Transformer Encoder**

**Fig. 15**

Integrated data and semantics encoding system

| Arithmetic encoding module 151 | Data-semantic information transformation module 152 | Semantic encoding module 113 |

F(0)  F(1)                    1

F(0)                        F(1)

P(00)          P(00)

**Arithmetic encoding**

Convolution layer

Reshape layer

Fully-connected layer

**Fully-connected layer**

Add&Norm

FFN

Add&Norm

Multi-head
Attention

**Transformer Encoder**

**Fig. 16**

Integrated data and semantics encoding system

LZ encoding module 161 → Data-semantic information transformation module 162 → Semantic encoding module 113

**Sentence encoding**

**Phrase dictionary**

**Obtain coding**

**LZ encoding**

**Convolution layer**

**Reshape layer**

**Fully-connected layer**

**Add&Norm**

**FFN**

**Add&Norm**

**Multi-head Attention**

**Transformer Encoder**

**Fig. 17**

Classical encoding module 171 → Data-semantic information transformation module 172 → Semantic encoding module 173 → Channel 174 → Semantic decoding module 175

English input

Chinese output

**Fig. 18**

Vector matrix determination system

**Encoding module** — 182

**Data semantic transformation module** — 184

## INTERNATIONAL SEARCH REPORT

| International application No. |
|---|
| **PCT/CN2023/142953** |

**A. CLASSIFICATION OF SUBJECT MATTER**

G06F40/284(2020.01)i

According to International Patent Classification (IPC) or to both national classification and IPC

**B. FIELDS SEARCHED**

Minimum documentation searched (classification system followed by classification symbols)

IPC: G06F G06K H04L

Documentation searched other than minimum documentation to the extent that such documents are included in the fields searched

Electronic data base consulted during the international search (name of data base and, where practicable, search terms used)

DWPI, CNTXT, ENTXTC, CNKI, 3GPP: 语义通信, 经典通信, 语义, 码字, 长度, 相同, 相等, 一致, 不同, 不相等, 向量, 矩阵, huffman, 全连接, 编码, Semantic Communication, Classic Communication, Semantic, Codeword, Length, Same, Equal, identical, Consistent, Different, Unequal, Vector, Matrix, huffman, Fully Connected, Encoded

**C. DOCUMENTS CONSIDERED TO BE RELEVANT**

| Category* | Citation of document, with indication, where appropriate, of the relevant passages | Relevant to claim No. |
|---|---|---|
| A | CN 115955297 A (NATIONAL UNIVERSITY OF DEFENSE TECHNOLOGY OF PLA) 11 April 2023 (2023-04-11)<br>  description, paragraphs 2, 3 and 22 | 1-16 |
| A | CN 111158640 A (INSTITUTE OF SOFTWARE, CHINESE ACADEMY OF SCIENCES) 15 May 2020 (2020-05-15)<br>  entire document | 1-16 |
| A | CN 112836506 A (NATIONAL UNIVERSITY OF DEFENSE TECHNOLOGY OF PLA) 25 May 2021 (2021-05-25)<br>  entire document | 1-16 |
| A | CN 115309869 A (NANJING UNIVERSITY OF POSTS AND TELECOMMUNICATIONS) 08 November 2022 (2022-11-08)<br>  entire document | 1-16 |
| A | CN 116010917 A (MOQI TECHNOLOGY (BEIJING) CO., LTD.) 25 April 2023 (2023-04-25)<br>  entire document | 1-16 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **02 April 2024** | **11 April 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/142953**

**C.** **DOCUMENTS CONSIDERED TO BE RELEVANT**

| Category* | Citation of document, with indication, where appropriate, of the relevant passages | Relevant to claim No. |
|---|---|---|
| A | US 11501580 B1 (KING SAUD UNIVERSITY) 15 November 2022 (2022-11-15)<br>entire document | 1-16 |
| A | 周辉 等 (ZHOU, Hui et al.). "一种实现信源信道联合编译码的新方法 (A Novel Joint Source Channel Coding)"<br>科技导报 (Science & Technology Review), No. 10, 31 May 2007 (2007-05-31),<br>entire document | 1-16 |

Form PCT/ISA/210 (second sheet) (July 2022)

**INTERNATIONAL SEARCH REPORT**
Information on patent family members

International application No.

**PCT/CN2023/142953**

| Patent document cited in search report | | | Publication date (day/month/year) | Patent family member(s) | Publication date (day/month/year) |
|---|---|---|---|---|---|
| CN | 115955297 | A | 11 April 2023 | None | |
| CN | 111158640 | A | 15 May 2020 | None | |
| CN | 112836506 | A | 25 May 2021 | None | |
| CN | 115309869 | A | 08 November 2022 | None | |
| CN | 116010917 | A | 25 April 2023 | None | |
| US | 11501580 | B1 | 15 November 2022 | None | |

Form PCT/ISA/210 (patent family annex) (July 2022)

**REFERENCES CITED IN THE DESCRIPTION**

**Patent documents cited in the description**

- CN 202310567601X